# EUROPEAN PATENT SPECIFICATION

(11) **EP 4 245 585 B1**
(45) Date of publication and mention of the grant of the patent: **03.12.2025**
(21) Application number: 21896287.6
(22) Date of filing: 21.06.2021
(51) Int. Cl.: B60K 11/02, B60R 16/02, F01P 7/14, F01P 5/10, F01P 3/12, F01P 3/20, F01P 7/16, F04B 49/06, F04B 49/20, H05K 7/20

(54) **LIQUID COOLING SYSTEM, CONTROL METHOD AND CONTROL DEVICE APPLIED THERETO**
FLÜSSIGKEITSKÜHLSYSTEM, STEUERUNGSVERFAHREN UND STEUERUNGSVORRICHTUNG DAFÜR
SYSTÈME DE REFROIDISSEMENT PAR LIQUIDE, PROCÉDÉ DE COMMANDE ET DISPOSITIF DE COMMANDE APPLIQUÉ À CELUI-CI

(30) Priority: 30.11.2020 CN 202011376695
(43) Date of publication of application: 20.09.2023
(60) Divisional application: 25212473.0
(73) Proprietor: Shenzhen Yinwang Intelligent Technologies Co., Ltd., Shenzhen, Guangdong 518129 (CN)
(72) Inventor: JIA, Hui, Shenzhen, Guangdong 518129 (CN); XU, Xiaobing, Shenzhen, Guangdong 518129 (CN)
(74) Representative: Pfenning, Meinig & Partner mbB
(86) International application number: PCT/CN2021/101151
(87) International publication number: WO 2022/110779

(56) References cited:
- EP-B1- 1 461 517
- CN-A- 109 552 021
- CN-A- 109 552 021
- CN-A- 110 239 383
- CN-A- 110 758 088
- CN-A- 111 347 833
- CN-A- 111 347 833
- CN-U- 210 680 637
- CN-U- 210 680 637
- JP-A- 2014 121 999
- US-A1- 2020 072 118
- US-B1- 6 352 055

## Description

### TECHNICAL FIELD

This disclosure generally relates to the field of heat dissipation, and the invention more specifically relates to a liquid cooling system, a control method and control apparatus applied to the liquid cooling system.

### BACKGROUND

Intelligent driving is a mainstream application in the field of artificial intelligence (artificial intelligence, AI). An intelligent driving technology relies on collaborative cooperation between computer vision, a radar, a monitoring apparatus, a global positioning system, and the like, so that a motor vehicle can implement intelligent driving without manual operations. One of key components in intelligent driving vehicles is an intelligent driving control component (for example, an advanced driving assistance system (advanced driving assistance system, ADAS) or a mobile data center (mobile data center, MDC)). The intelligent driving control component generates a large amount of heat in a working process thereof. To ensure that working performance is not affected, heat from the intelligent driving control component needs to be dissipated.

Common heat dissipation modes include air cooling heat dissipation and liquid cooling heat dissipation. As a computing power requirement of the intelligent driving control component increases, a power of the intelligent driving control component becomes higher, and a heat dissipation problem of the intelligent driving control component cannot be further resolved through air cooling. Therefore, liquid cooling is required for heat dissipation. Because there is a liquid cooling system in the vehicle, how to use the existing liquid cooling system to dissipate heat for the intelligent driving control component and meet an energy saving requirement of the entire vehicle becomes a new problem.
US 6,352,055 B1 discloses a control system for controlling engine coolant flow in an engine including a first sensor positioned to sense the temperature of a first fluid in the engine and a second sensor positioned to sense the temperature of a second fluid in the engine, an electronic controller coupled with the first and second sensors to receive signals therefrom indicative of the respective temperatures of the first and second fluids, the controller being operable to determine an appropriate pump speed for each of the respective fluids based upon the temperature associated respectively therewith and thereafter outputting a signal to the engine coolant pump motor to control the speed thereof, the outputted signal being indicative of the highest pump speed dictated by the signals received from the first and second sensor:
CN210680637U discloses an intelligent driving control component being cooled by a liquid cooling system.

### SUMMARY

The object of the present invention is to provide a liquid cooling system, a control method and control apparatus applied to the liquid cooling system such that the liquid cooling system can meet both a heat dissipation requirement of an intelligent driving control component and an energy saving requirement of an entire vehicle. This object is solved by the attached independent claims and further embodiments and improvements of the invention are listed in the attached dependent claims.

According to a first aspect according to the invention, the invention provides a liquid cooling system according to claim 1. this way, the intelligent driving control component participates in rotation speed control of the pump in the liquid cooling system, to meet both a heat dissipation requirement of the intelligent driving control component and an energy saving requirement of the entire vehicle.

With reference to the first aspect, in some implementations of the first aspect, the vehicle-mounted control module is further configured to determine the rotation speed of the pump based on a largest value of the pump rotation speed requirements of the plurality of vehicle-mounted components.

In this embodiment of this application, the rotation speed of the pump in the liquid cooling system may be determined based on the largest value of the pump rotation speed requirements of the plurality of vehicle-mounted components, so that the determined rotation speed of the pump can simultaneously meet heat dissipation requirements of the plurality of vehicle-mounted components.

With reference to the first aspect, in some implementations of the first aspect, a pump rotation speed requirement of each of the plurality of vehicle-mounted components is determined based on an inlet water temperature and a flow requirement of each vehicle-mounted component.

With reference to the first aspect, in some implementations of the first aspect, the plurality of vehicle-mounted components are respectively connected to a plurality of pipelines, the plurality of pipelines are connected in parallel, the plurality of pipelines are respectively connected to the pump and the heat exchanger to form a circulation loop, and the vehicle-mounted control module is separately connected to the pump and the plurality of vehicle-mounted components through lines.

With reference to the first aspect, in some implementations of the first aspect, the liquid cooling system further includes a temperature sensor, the temperature sensor is located at a liquid cooling inlet of the plurality of vehicle-mounted components, and the temperature sensor is configured to measure the inlet water temperature.

It should be understood that the temperature difference is a difference between the temperature specification and the actual temperature. The temperature specification refers to a temperature that can be borne by a current location. A lower temperature difference indicates that the actual temperature is closer to the temperature specification, and is more unfavorable to normal operation of the component. Therefore, that the pump rotation speed requirement is determined based on the temperature difference is more favorable to the normal operation of the component.

In addition, for the intelligent driving control component, temperature differences of the component at different locations may be different in a working process. If heat dissipation is controlled only based on a pump rotation speed requirement determined by a temperature difference at a location, a heat dissipation requirement of another location may not be met. This is also unfavorable to the normal operation of the entire component.

Therefore, in this embodiment of this application, the pump rotation speed requirement of the intelligent driving control component is determined based on the temperature differences at the plurality of locations on the intelligent driving control component, to meet the heat dissipation requirements at the different locations on the intelligent driving control component.

With reference to the first aspect, in some implementations of the first aspect, the pump rotation speed requirement of the intelligent driving control component is determined based on a smallest value of the temperature differences at the plurality of locations on the intelligent driving control component.

In this embodiment of this application, the pump rotation speed requirement of the intelligent driving control component is determined based on the smallest value of the temperature differences at the plurality of locations on the intelligent driving control component, so that the determined pump rotation speed requirement can meet the heat dissipation requirements at the different locations on the intelligent driving control component.

With reference to the first aspect, in some not claimed implementations of the first aspect, the pump rotation speed requirement of the intelligent driving control component is determined based on a temperature range in which the smallest value of the temperature differences at the plurality of locations on the intelligent driving control component falls.

With reference to the first aspect, in some implementations of the first aspect, a pump rotation speed requirement of the intelligent driving control component is determined based on temperature differences and, although not claimed, heating rates at a plurality of locations on the intelligent driving control component, and the temperature difference is a difference between a temperature specification and an actual temperature.

It should be understood that the temperature difference can reflect a difference between the temperature specification and the actual temperature. The temperature specification refers to a temperature that can be borne by a current location. A lower temperature difference indicates that the actual temperature is closer to the temperature specification, and is more unfavorable to normal operation of the component. Therefore, that the pump rotation speed requirement is determined based on the temperature difference is more favorable to the normal operation of the component.

It should be understood that the heating rate can reflect a power change at a location on the intelligent driving control component, and a change in the heating rate means that a working power at a current location changes. The pump rotation speed requirement is determined based on the heating rates at the plurality of locations on the intelligent driving control component, so that when a power of a heating component such as the intelligent driving control component increases sharply, the pump can be adjusted in time, to implement heat dissipation.

In addition, for the intelligent driving control component, temperature differences and heating rates of the component at different locations in a working process may be different. If heat dissipation is controlled only based on a pump rotation speed requirement determined by a temperature difference and a heating rate at a location, heat dissipation requirements of other parts may not be met.

Therefore, in this 'not claimed embodiment of this application, the pump rotation speed requirement of the intelligent driving control component is determined based on the temperature differences and heating rates at the plurality of locations on the intelligent driving control component, to meet heat dissipation requirements at the different locations on the intelligent driving control component.

With reference to the first aspect, in some implementations of the first aspect, the pump rotation speed requirement of the intelligent driving control component is determined based on a smallest value of the temperature differences and, although not claimed, a largest value of the heating rates at the plurality of locations on the intelligent driving control component.

With reference to the first aspect, in some not claimed implementations of the first aspect, the pump rotation speed requirement of the intelligent driving control component is determined based on a larger one of a first pump rotation speed requirement and a second pump rotation speed requirement, where the first pump rotation speed requirement is determined based on the smallest value of the temperature differences at the plurality of locations on the intelligent driving control component, and the second pump rotation speed requirement is determined based on the largest value of the heating rates at the plurality of locations on the intelligent driving control component.

In this not claimed embodiment of this application, the pump rotation speed requirement of the intelligent driving control component is determined by using a larger one of the first pump rotation speed requirement determined based on the smallest value of the temperature differences at the plurality of locations on the intelligent driving control component and the second pump rotation speed requirement determined based on the largest value of the heating rates at the plurality of locations on the intelligent driving control component, so that the pump rotation speed requirement can simultaneously meet heat dissipation requirements at different locations on the intelligent driving control component, and can adjust the pump rotation speed in time to perform heat dissipation when powers at some locations increase sharply.

With reference to the first aspect, in some not claimed implementations of the first aspect, the first pump rotation speed requirement is determined based on a temperature range in which the smallest value of the temperature differences at the plurality of locations on the intelligent driving control component falls, and/or the second pump rotation speed requirement is determined based on a rate range in which the largest value of the heating rates at the plurality of locations on the intelligent driving control component falls.

With reference to the first aspect, in some not claimed implementations of the first aspect, the pump rotation speed requirement of the intelligent driving control component is determined based on the inlet water temperature.

With reference to the first aspect, in some not claimed implementations of the first aspect, the pump rotation speed requirement of the intelligent driving control component is determined based on a temperature range in which the inlet water temperature falls.

With reference to the first aspect, in some not claimed implementations of the first aspect, the pump rotation speed requirement of the intelligent driving control component is determined based on a junction temperature of a core chip on the intelligent driving control component.

With reference to the first aspect, in some not claimed implementations of the first aspect, the pump rotation speed requirement of the intelligent driving control component is determined based on a temperature range in which the junction temperature of the core chip on the intelligent driving control component falls.

According to a second aspect according to the invention, the invention also provides a control method according to claim 7.

With reference to the second aspect, in some implementations of the second aspect, the determining a rotation speed of the pump based on the pump rotation speed requirements of the plurality of vehicle-mounted components includes: determining the rotation speed of the pump based on a largest value of the pump rotation speed requirements of the plurality of vehicle-mounted components.

With reference to the second aspect, in some implementations of the second aspect, the control method further includes: determining the pump rotation speed requirements of the plurality of vehicle-mounted components based on an inlet water temperature and a flow requirement of each of the plurality of vehicle-mounted components.

With reference to the second aspect, according to the invention of the second aspect, the determining a pump rotation speed requirement of the intelligent driving control component based on temperature differences at a plurality of locations on the intelligent driving control component includes: determining the pump rotation speed requirement of the intelligent driving control component based on a smallest value of the temperature differences at the plurality of locations on the intelligent driving control component.

With reference to the second aspect, in some implementations of the second aspect, the determining the pump rotation speed requirement of the intelligent driving control component based on a smallest value of the temperature differences at the plurality of locations on the intelligent driving control component includes: determining a temperature range in which the smallest value of the temperature differences at the plurality of locations on the intelligent driving control component falls; and determining the pump rotation speed requirement of the intelligent driving control component based on the temperature range in which the smallest value of the temperature differences at the plurality of locations on the intelligent driving control component falls.

With reference to the second aspect, in some implementations of the second aspect, the control method further includes: determining a pump rotation speed requirement of the intelligent driving control component based on temperature differences and heating rates at a plurality of locations on the intelligent driving control component, where the temperature difference is a difference between a temperature specification and an actual temperature.

With reference to the second aspect, in some not claimed implementations of the second aspect, the determining a pump rotation speed requirement of the intelligent driving control component based on temperature differences and heating rates at a plurality of locations on the intelligent driving control component includes: determining the pump rotation speed requirement of the intelligent driving control component based on a smallest value of the temperature differences and a largest value of the heating rates at the plurality of locations on the intelligent driving control component.

With reference to the second aspect, in some not claimed implementations of the second aspect, the determining the pump rotation speed requirement of the intelligent driving control component based on a smallest value of the temperature differences and a largest value of the heating rates at the plurality of locations on the intelligent driving control component includes: determining a first pump rotation speed requirement based on the smallest value of the temperature differences at the plurality of locations on the intelligent driving control component; determining a second pump rotation speed requirement based on a largest value of the heating rates at the plurality of locations on the intelligent driving control component; and determining the pump rotation speed requirement of the intelligent driving control component based on a larger one of the first pump rotation speed requirement and the second pump rotation speed requirement.

With reference to the second aspect, in some not claimed implementations of the second aspect, the determining a first pump rotation speed requirement based on the smallest value of the temperature differences at the plurality of locations on the intelligent driving control component includes: determining a temperature range in which the smallest value of the temperature differences at the plurality of locations on the intelligent driving control component falls; and determining the first pump rotation speed requirement based on the temperature range in which the smallest value of the temperature differences at the plurality of locations on the intelligent driving control component falls; and/or the determining a second pump rotation speed requirement based on a largest value of the heating rates at the plurality of locations on the intelligent driving control component includes: determining a rate range in which the largest value of the heating rates at the plurality of locations on the intelligent driving control component falls; and determining the second pump rotation speed requirement based on the rate range in which the largest value of the heating rates at the plurality of locations on the intelligent driving control component falls.

With reference to the second aspect, in some implementations of the second aspect, the control method further includes: determining the pump rotation speed requirement of the intelligent driving control component based on the inlet water temperature.

With reference to the second aspect, in some not claimed implementations of the second aspect, the determining the pump rotation speed requirement of the intelligent driving control component based on the inlet water temperature includes: determining a temperature range in which the inlet water temperature falls; and determining the pump rotation speed requirement of the intelligent driving control component based on the temperature range in which the inlet water temperature falls.

With reference to the second aspect, in some not claimed implementations of the second aspect, the control method further includes: determining the pump rotation speed requirement of the intelligent driving control component based on a junction temperature of a core chip on the intelligent driving control component.

With reference to the second aspect, in some not claimed implementations of the second aspect, the determining the pump rotation speed requirement of the intelligent driving control component based on a junction temperature of a core chip on the intelligent driving control component includes: determining a temperature range in which the junction temperature of the core chip on the intelligent driving control component falls; and determining the pump rotation speed requirement of the intelligent driving control component based on the temperature range in which the junction temperature of the core chip on the intelligent driving control component falls.

According to a third aspect according to the invention, the invention also provides a control apparatus according to claim 12.

With reference to the third aspect, in some implementations of the third aspect, the controller is further configured to determine the rotation speed of the pump based on a largest value of the pump rotation speed requirements of the plurality of vehicle-mounted components.

With reference to the third aspect, in some implementations of the third aspect, the controller is further configured to determine the pump rotation speed requirements of the plurality of vehicle-mounted components based on an inlet water temperature and, although not claimed, a flow requirement of each of the plurality of vehicle-mounted components.

With reference to the third aspect, in some implementations of the third aspect, the controller is further configured to determine the pump rotation speed requirement of the intelligent driving control component based on a smallest value of the temperature differences at the plurality of locations on the intelligent driving control component.

With reference to the third aspect, in some implementations of the third aspect, the controller is further configured to determine a temperature range in which the smallest value of the temperature differences at the plurality of locations on the intelligent driving control component falls; and determine the pump rotation speed requirement of the intelligent driving control component based on the temperature range in which the smallest value of the temperature differences at the plurality of locations on the intelligent driving control component falls.

With reference to the third aspect, in some implementations of the third aspect, the controller is further configured to determine a pump rotation speed requirement of the intelligent driving control component based on temperature differences and heating rates at a plurality of locations on the intelligent driving control component, where the temperature difference is a difference between a temperature specification and an actual temperature.

With reference to the third aspect, in some not claimed implementations of the third aspect, the controller is further configured to determine the pump rotation speed requirement of the intelligent driving control component based on a smallest value of the temperature differences and a largest value of the heating rates at the plurality of locations on the intelligent driving control component.

With reference to the third aspect, in some not claimed implementations of the third aspect, the controller is further configured to: determine a first pump rotation speed requirement based on the smallest value of the temperature differences at the plurality of locations on the intelligent driving control component; determine a second pump rotation speed requirement based on a largest value of the heating rates at the plurality of locations on the intelligent driving control component; and determine the pump rotation speed requirement of the intelligent driving control component based on a larger one of the first pump rotation speed requirement and the second pump rotation speed requirement.

With reference to the third aspect, in some implementations of the third aspect, the controller is further configured to: determine a temperature range in which the smallest value of the temperature differences at the plurality of locations on the intelligent driving control component falls; and determine the first pump rotation speed requirement based on the temperature range in which the smallest value of the temperature differences at the plurality of locations on the intelligent driving control component falls; and/or the controller is further configured to: determine a rate range in which the largest value of the heating rates at the plurality of locations on the intelligent driving control component falls; and determine the second pump rotation speed requirement based on the rate range in which the largest value of the heating rates at the plurality of locations on the intelligent driving control component falls.

With reference to the third aspect, in some implementations of the third aspect, the controller is further configured to determine the pump rotation speed requirement of the intelligent driving control component based on the inlet water temperature.

With reference to the third aspect, in some implementations of the third aspect, the controller is further configured to: determine a temperature range in which the inlet water temperature falls; and determine the pump rotation speed requirement of the intelligent driving control component based on the temperature range in which the inlet water temperature falls.

With reference to the third aspect, in some not claimed implementations of the third aspect, the controller is further configured to determine the pump rotation speed requirement of the intelligent driving control component based on a junction temperature of a core chip on the intelligent driving control component.

With reference to the third aspect, in some not claimed implementations of the third aspect, the controller is further configured to: determine a temperature range in which the junction temperature of the core chip on the intelligent driving control component falls; and determine the pump rotation speed requirement of the intelligent driving control component based on the temperature range in which the junction temperature of the core chip on the intelligent driving control component falls.

According to a fourth aspect according to the invention, the invention also provides a control apparatus applied to a liquid cooling system according to the first aspect, including an input/output interface, a processor, and a memory, where the processor is configured to control the input/output interface to receive and send a signal or information, the memory is configured to store a computer program, and the processor is configured to invoke and run the computer program from the memory, so that the control apparatus performs the method in any one of the second aspect or the possible implementations of the second aspect.

According to a fifth not claimed aspect, a vehicle is provided, including the system in any one of the first aspect or the possible implementations of the first aspect, and/or the control apparatus in any one of the third aspect or the possible implementations of the third aspect.

According to a sixth not claimed aspect, a computing device is provided, including at least one processor and a memory, where the at least one processor is coupled to the memory, and is configured to read and execute instructions in the memory, to perform the control method in any one of the second aspect or the possible implementations of the second aspect.

According to a seventh not claimed aspect, a computer-readable medium is provided. The computer-readable medium stores program code, and when the computer program code is run on a computer, the computer is enabled to perform the control method in any one of the second aspect or the possible implementations of the second aspect.

According to an eighth not claimed aspect, a computer program product including instructions is provided. When the computer program product is run on a computer, the computer is enabled to perform the control method in any one of the second aspect or the possible implementations of the second aspect.

According to a ninth not claimed aspect, a chip is provided. The chip includes a processor and a data interface, and the processor reads, by using the data interface, instructions stored in a memory, to perform the control method in any one of the second aspect or the possible implementations of the second aspect.

Optionally, in a not claimed implementation, the chip may further include a memory. The memory stores instructions, and the processor is configured to execute the instructions stored in the memory. When the instructions are executed, the processor is configured to perform the control method in any one of the second aspect or the possible implementations of the second aspect.

### BRIEF DESCRIPTION OF DRAWINGS

FIG. 1 is a functional block diagram of a vehicle 100 according to an embodiment of this application;
FIG. 2 is an example diagram of an intelligent driving system according to an embodiment of this application;
FIG. 3 is an example diagram of an application of a cloud-side instruction-based intelligent driving vehicle according to an embodiment of this application;
FIG. 4 is an example diagram of a system architecture of a liquid cooling system according to an embodiment of this application;
FIG. 5 is an example diagram of a pump rotation speed control policy applied to a liquid cooling system according to an embodiment of this application;
FIG. 6 is an example diagram of a control method applied to a liquid cooling system according to an embodiment of this application;
FIG. 7 is an example diagram of a control apparatus applied to a liquid cooling system according to an embodiment of this application; and
FIG. 8 is an example block diagram of a hardware structure of a control apparatus according to an embodiment of this application.

### DESCRIPTION OF EMBODIMENTS

The following describes technical solutions of this application with reference to accompanying drawings.

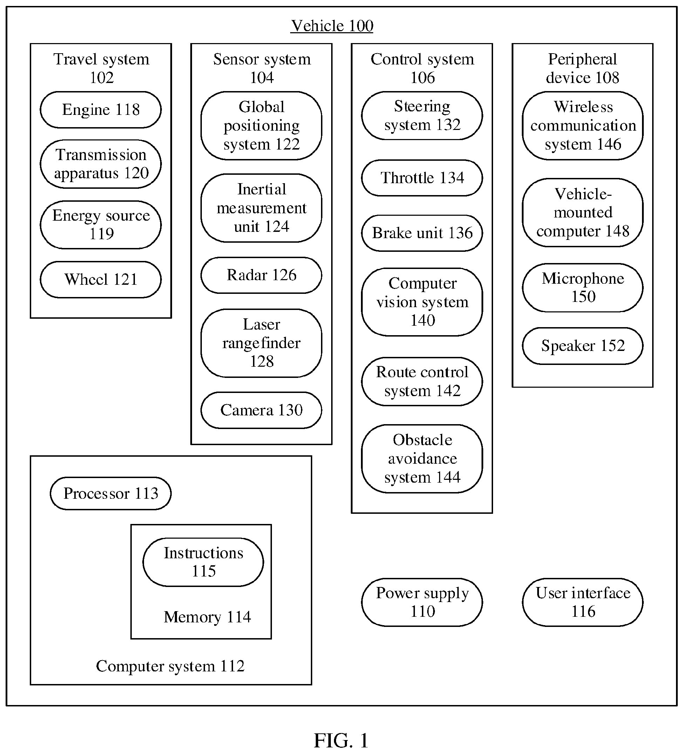

FIG. 1 is a functional block diagram of a vehicle 100 according to an embodiment of this application. In an embodiment, the vehicle 100 is configured to be in a fully or partially intelligent driving mode.

For example, the vehicle 100 in the intelligent driving mode may control the vehicle 100. A manual operation may be performed to determine current states of the vehicle and an ambient environment of the vehicle, determine a possible behavior of at least one another vehicle in the ambient environment, determine confidence corresponding to a possibility that the another vehicle performs the possible behavior, and control the vehicle 100 based on determined information. When the vehicle 100 is in the intelligent driving mode, the vehicle 100 may be set to operate without interacting with a person.

The vehicle 100 may include various subsystems, for example, a travel system 102, a sensor system 104, a control system 106, one or more peripheral devices 108, a power supply 110, a computer system 112, and a user interface 116. Optionally, the vehicle 100 may include more or fewer subsystems, and each subsystem may include a plurality of components. In addition, each subsystem and component of the vehicle 100 may be interconnected in a wired or wireless manner.

The travel system 102 may include a component that provides power for the vehicle 100 to move. In an embodiment, the travel system 102 may include an engine 118, an energy source 119, a transmission apparatus 120, and wheels/tires 121. The engine 118 may be an internal combustion engine, a motor, an air compression engine, or another type of engine combination, for example, a hybrid engine including a gasoline engine and a motor, or a hybrid engine including an internal combustion engine and an air compression engine. The engine 118 converts the energy source 119 into mechanical energy.

Examples of the energy source 119 include gasoline, diesel, other oil-based fuels, propane, other compressed gas-based fuels, ethanol, solar panels, batteries, or other power sources. The energy source 119 may also provide energy to another system of the vehicle 100.

The transmission apparatus 120 may transmit mechanical power from the engine 118 to the wheel 121. The transmission apparatus 120 may include a gearbox, a differential, and a drive shaft. In an embodiment, the transmission apparatus 120 may further include another component, for example, a clutch. The drive shaft may include one or more shafts that may be coupled to one or more wheels 121.

The sensor system 104 may include several sensors that can sense information about the ambient environment of the vehicle 100. For example, the sensor system 104 may include a positioning system 122 (the positioning system may be a global positioning system (global positioning system, GPS), or may be a BeiDou system or another positioning system), an inertial measurement unit (inertial measurement unit, IMU) 124, a radar 126, a laser rangefinder 128, and a camera 130. The sensor system 104 may further include sensors (for example, an in-vehicle air quality monitor, a fuel gauge, and an oil temperature gauge) in an internal system of the monitored vehicle 100. Sensor data from one or more of these sensors can be used to detect an object and corresponding features (a location, a shape, a direction, a speed, and the like) of the object. Such detection and recognition are key functions of a safe operation of the autonomous vehicle 100.

The positioning system 122 may be configured to estimate a geographical location of the vehicle 100. The IMU 124 is configured to sense a location and an orientation change of the vehicle 100 based on an inertial acceleration. In an embodiment, the IMU 124 may be a combination of an accelerometer and a gyroscope.

The radar 126 may sense an object in the ambient environment of the vehicle 100 by using a radio signal. In some embodiments, in addition to sensing an object, the radar 126 may further be configured to sense a speed and/or a moving direction of the object.

The laser rangefinder 128 may sense, by using a laser, an object in an environment in which the vehicle 100 is located. In some embodiments, the laser rangefinder 128 may include one or more laser sources, a laser scanner, one or more detectors, and another system component.

The camera 130 may be configured to capture a plurality of images of the ambient environment of the vehicle 100. The camera 130 may be a static camera or a video camera.

The control system 106 controls operations of the vehicle 100 and components of the vehicle 100. The control system 106 may include various components, including a steering system 132, a throttle 134, a brake unit 136, a sensor fusion algorithm 138, a computer vision system 140, a route control system 142, and an obstacle avoidance system 144.

The steering system 132 may be operated to adjust a moving direction of the vehicle 100. For example, in an embodiment, the steering system 132 may be a steering wheel system.

The throttle 134 is configured to control an operating speed of the engine 118 and further control a speed of the vehicle 100.

The brake unit 136 is configured to control the vehicle 100 to decelerate. The brake unit 136 may use friction to slow down the wheel 121. In another embodiment, the brake unit 136 may convert kinetic energy of the wheel 121 into a current. The brake unit 136 may alternatively use another form to reduce a rotation speed of the wheel 121, to control the speed of the vehicle 100.

The computer vision system 140 may operate to process and analyze an image captured by the camera 130, to identify an object and/or a feature in the ambient environment of the vehicle 100. The object and/or the feature may include a traffic signal, a road boundary, and an obstacle. The computer vision system 140 may use an object recognition algorithm, a structure from motion (Structure from Motion, SFM) algorithm, video tracking, and another computer vision technology. In some embodiments, the computer vision system 140 may be configured to draw a map for an environment, track an object, estimate a speed of the object, and the like.

The route control system 142 is configured to determine a travel route of the vehicle 100. In some embodiments, the route control system 142 may determine the travel route for the vehicle 100 based on data from the sensor 138, the GPS 122, and one or more predetermined maps.

The obstacle avoidance system 144 is configured to identify, evaluate, and avoid or bypass a potential obstacle in the environment of the vehicle 100 in another manner.

Certainly, in an example, the control system 106 may add or alternatively include components other than those shown and described. Alternatively, the control system 106 may delete some of the foregoing components.

The vehicle 100 interacts with an external sensor, another vehicle, another computer system, or a user by using the peripheral device 108. The peripheral device 108 may include a wireless communication system 146, a vehicle-mounted computer 148, a microphone 150, and/or a speaker 152.

In some embodiments, the peripheral device 108 provides a means for a user of the vehicle 100 to interact with the user interface 116. For example, the vehicle-mounted computer 148 may provide information for the user of the vehicle 100. The user interface 116 may further operate the vehicle-mounted computer 148 to receive a user input. The vehicle-mounted computer 148 may perform operations through a touchscreen. In another case, the peripheral device 108 may provide a means for the vehicle 100 to communicate with another device located in the vehicle. For example, the microphone 150 may receive audio (for example, a voice command or another audio input) from the user of the vehicle 100. Likewise, the speaker 152 may output audio to the user of the vehicle 100.

The wireless communication system 146 may wirelessly communicate with one or more devices directly or through a communication network. For example, the wireless communication system 146 may use 3G cellular communication such as code division multiple access (code division multiple access, CDMA), a global system for mobile communications (global system for mobile communications, GSM), or general packet radio service (general packet radio service, GPRS); 4G cellular communication such as long term evolution (long term evolution, LTE); or 5G cellular communication. The wireless communication system 146 may communicate with a wireless local area network (wireless local area network, WLAN) through Wi-Fi. In some embodiments, the wireless communication system 146 may directly communicate with a device by using an infrared link, Bluetooth, or the like. Other wireless protocols, for example, various vehicle communication systems such as the wireless communication system 146, may include one or more dedicated short range communication (dedicated short range communication, DSRC) devices, which may include public and/or private data communication between vehicles and/or roadside stations.

The power supply 110 may provide power to various components of the vehicle 100. In an embodiment, the power supply 110 may be a rechargeable lithium-ion or lead-acid battery. One or more battery packs of such a battery may be configured as the power supply to supply power to the components of the vehicle 100. In some embodiments, the power supply 110 and the energy source 119 may be implemented together, for example, in some pure electric vehicles.

Some or all of functions of the vehicle 100 are controlled by the computer system 112. The computer system 112 may include at least one processor 113, and the processor 113 executes instructions 115 stored in a non-transient computer-readable medium such as the memory 114. The computer system 112 may alternatively be a plurality of computing devices that control an individual component or a subsystem of the vehicle 100 in a distributed manner.

The processor 113 may be any conventional processor, for example, a commercially available CPU. Optionally, the processor may be a dedicated device such as an ASIC or another hardware-based processor. Although FIG. 1 functionally illustrates the processor, the memory, and other elements of a computer 110 in a same block, a person of ordinary skill in the art should understand that the processor, the computer, or the memory may actually include a plurality of processors, computers, or memories that may or may not be stored in a same physical housing. For example, the memory may be a hard disk drive, or another storage medium located in a housing different from that of the computer 110. Therefore, it is understood that a reference to the processor or the computer includes a reference to a set of processors or computers or memories that may or may not operate in parallel. Different from using a single processor to perform the steps described herein, some components such as a steering component and a deceleration component may include respective processors. The processor performs only computation related to a component-specific function.

In various aspects described herein, the processor may be located far away from the vehicle and wirelessly communicate with the vehicle. In another aspect, some processes described herein are performed on a processor disposed inside the vehicle, while others are performed by a remote processor, including performing steps necessary for single manipulation.

In some embodiments, the memory 114 may include the instructions 115 (for example, program logic), and the instructions 115 may be executed by the processor 113 to perform various functions of the vehicle 100, including the functions described above. The memory 114 may also include additional instructions, including instructions used to send data to, receive data from, interact with, and/or control one or more of the travel system 102, the sensor system 104, the control system 106, and the peripheral device 108.

In addition to the instructions 115, the memory 114 may further store data, such as a road map, route information, and a location, a direction, a speed, and other such vehicle data of the vehicle, and other information. Such information may be used by the vehicle 100 and the computer system 112 when the vehicle 100 operates in an autonomous mode, a semi-autonomous mode, and/or a manual mode.

The user interface 116 is used to provide information for or receive information from the user of the vehicle 100. Optionally, the user interface 116 may include one or more input/output devices in a set of peripheral devices 108, for example, the wireless communication system 146, the vehicle-mounted computer 148, the microphone 150, and the speaker 152.

The computer system 112 may control functions of the vehicle 100 based on input received from various subsystems (for example, the travel system 102, the sensor system 104, and the control system 106) and from the user interface 116. For example, the computer system 112 may access and use input from the control system 106 to control the steering unit 132 to avoid an obstacle detected by the sensor system 104 and the obstacle avoidance system 144. In some embodiments, the computer system 112 may operate to provide control on the vehicle 100 and the subsystems of the vehicle 100 in many aspects.

Optionally, one or more of the foregoing components may be installed separately from or associated with the vehicle 100. For example, the memory 114 may be partially or completely separated from the vehicle 100. The foregoing components may be communicatively coupled together in a wired and/or wireless manner.

Optionally, the foregoing components are merely examples. During actual application, components in the foregoing modules may be added or removed based on an actual requirement. FIG. 1 should not be construed as a limitation on this embodiment of this application.

An intelligent driving vehicle traveling on a road, for example, the vehicle 100, may identify an object in an ambient environment of the intelligent driving vehicle, to determine to adjust a current speed. The object may be another vehicle, a traffic control device, or another type of object. In some examples, each identified object may be considered independently, and based on features of each object, such as a current speed of the object, an acceleration of the object, and a spacing between the object and the vehicle, may be used to determine the speed to be adjusted by the intelligent driving vehicle.

Optionally, the intelligent driving vehicle 100 or a computing device associated with the intelligent driving vehicle 100 (for example, the computer system 112, the computer vision system 140, or the memory 114 in FIG. 1) may predict a behavior of the identified object based on a feature of the identified object and a state of the ambient environment (for example, traffic, rain, and ice on a road). Optionally, all identified objects depend on a behavior of each other, and therefore all the identified objects may be considered together to predict a behavior of a single identified object. The vehicle 100 can adjust the speed of the vehicle 100 based on the predicted behavior of the identified object. In other words, the intelligent driving vehicle can determine, based on the predicted behavior of the object, a stable state to which the vehicle needs to be adjusted (for example, acceleration, deceleration, or stop). In this process, another factor may also be considered to determine the speed of the vehicle 100, for example, a horizontal location of the vehicle 100 on a road on which the vehicle travels, curvature of the road, and proximity between a static object and a dynamic object.

In addition to providing instructions for adjusting the speed of the intelligent driving vehicle, the computing device may further provide instructions for changing a steering angle of the vehicle 100, so that the intelligent driving vehicle follows a given track and/or maintains safe lateral and longitudinal distances between the intelligent driving vehicle and an object (for example, a car in an adjacent lane on the road) near the intelligent driving vehicle.

Optionally, the intelligent driving vehicle 100 or a computing device associated with the intelligent driving vehicle 100 (for example, the computer system 112, the computer vision system 140, and the memory 114 in FIG. 1) may predict, based on a state of the vehicle and detected environment information, whether the intelligent driving on the road ahead is available, and control switching between the intelligent driving mode and a manual driving mode.

The vehicle 100 may be a car, a truck, a motorcycle, a bus, a boat, an airplane, a helicopter, a lawn mower, a recreational vehicle, a playground vehicle, a construction device, a trolley, a golf cart, a train, a handcart, or the like. This is not specifically limited in this embodiment of this application.

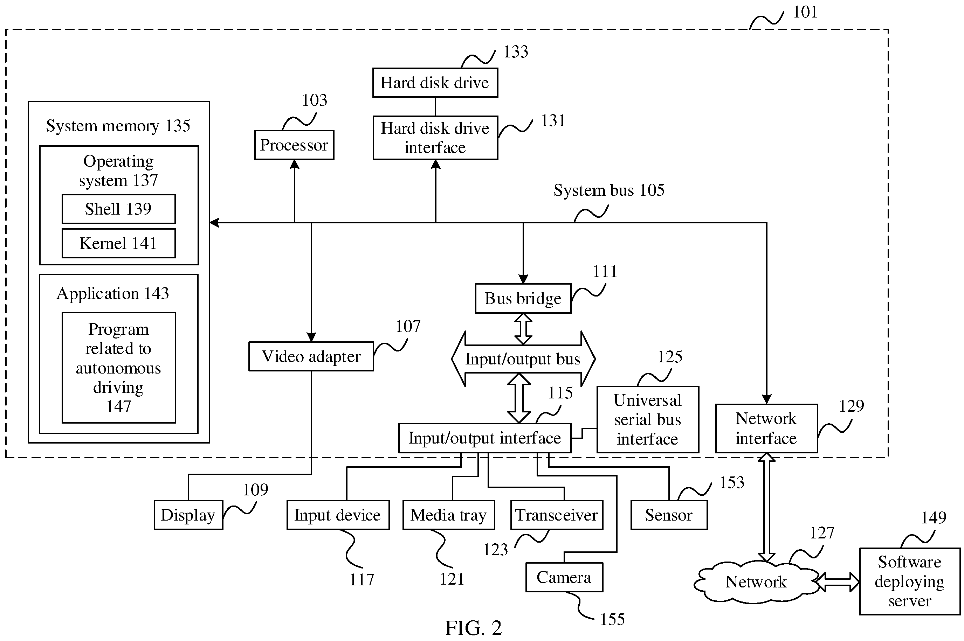

FIG. 2 is an example diagram of an intelligent driving system according to an embodiment of this application.

The intelligent driving system shown in FIG. 2 includes a computer system 101. The computer system 101 includes a processor 103, and the processor 103 is coupled to a system bus 105. The processor 103 may be one or more processors. Each processor may include one or more processor cores. The computer system 101 further includes a video adapter (video adapter) 107. The video adapter may drive a display 109. The display 109 is coupled to the system bus 105. The system bus 105 is coupled to an input/output (I/O) bus 113 through a bus bridge 111. An I/O interface 115 is coupled to the I/O bus. The I/O interface 115 communicates with a plurality of I/O devices, such as an input device 117 (for example, a keyboard, a mouse, and a touchscreen), a media tray (media tray) 121 (for example, a compact disc read-only memory (compact disc read-only memory, CD-ROM) or a multimedia interface), a transceiver 123 (which may send and/or receive a radio communication signal), a camera 155 (which may capture static and dynamic digital video images), and an external universal serial bus (universal serial bus, USB) interface 125. Optionally, an interface connected to the I/O interface 115 may be a USB interface.

The processor 103 may be any conventional processor, including a reduced instruction set computer (reduced instruction set computer, RISC) processor, a complex instruction set computer (complex instruction set computer, CISC) processor, or a combination thereof. Optionally, the processor may be a dedicated apparatus such as an application-specific integrated circuit (application-specific integrated circuit, ASIC). Optionally, the processor 103 may be a neural-network processor or a combination of the neural-network processor and the foregoing conventional processor.

Optionally, in various embodiments described in this application, the computer system 101 may be located away from an intelligent driving vehicle, and may wirelessly communicate with the intelligent driving vehicle. In other aspect, some of the processes described in this application are performed on a processor disposed inside an intelligent driving vehicle, and others are performed by a remote processor, including actions required to perform a single operation.

The computer 101 may communicate with a software deploying server 149 through a network interface 129. The network interface 129 is a hardware network interface, for example, a network interface card. A network 127 may be an external network such as the Internet, or an internal network such as the Ethernet or a virtual private network (virtual private network, VPN). Optionally, the network 127 may alternatively be a wireless network, for example, a Wi-Fi network or a cellular network.

A hard disk drive interface is coupled to the system bus 105. A hard disk drive interface is connected to the hard disk drive. A system memory 135 is coupled to the system bus 105. Data running in the system memory 135 may include an operating system 137 and an application 143 of the computer 101.

The operating system includes a shell (shell) 139 and a kernel (kernel) 141. The shell 139 is an interface between a user and the kernel (kernel) of the operating system. The shell is the outermost layer of the operating system. The shell manages interaction between the user and the operating system: waiting for an input from the user, interpreting the input from the user to the operating system, and processing various output results of the operating system.

The kernel 141 includes components of the operating system that are configured to manage a memory, a file, a peripheral, and a system resource. When directly interacting with hardware, the kernel of the operating system usually runs a process, provides inter-process communication, and provides functions such as CPU time slice management, interrupt, memory management, and I/O management.

The application 143 includes programs related to controlling intelligent driving of the vehicle, for example, a program that manages interaction between the intelligent driving vehicle and a road obstacle, a program that controls a route or a speed of the intelligent driving vehicle, a program that controls interaction between the intelligent driving vehicle and another intelligent driving vehicle on the road. The application 143 also exists in a system of the deploying server 149. In one embodiment, when the application 147 needs to be executed, the computer system 101 may download the application 143 from the deploying server 149.

For example, the application 141 may be a program that controls the intelligent driving vehicle to enable or disable an intelligent driving assistance function.

A sensor 153 is associated with the computer system 101. The sensor 153 is configured to detect an ambient environment of the computer 101. For example, the sensor 153 can detect animals, vehicles, obstacles, pedestrian crosswalks, and the like. Further, the sensor can detect ambient environments of the animals, the vehicles, the obstacles, or the pedestrian crosswalks. For example, the sensor can detect the ambient environment of animals such as other animals in the ambient environment, a weather condition, and brightness of the ambient environment. Optionally, if the computer 101 is located in the intelligent driving vehicle, the sensor may be a camera, an infrared sensor, a chemical detector, a microphone, or the like.

The computer system 112 in FIG. 1 may also receive information from or transfer information to other computer systems. Alternatively, the sensor data collected by the sensor system 104 of the vehicle 100 may be transferred to another computer for processing.

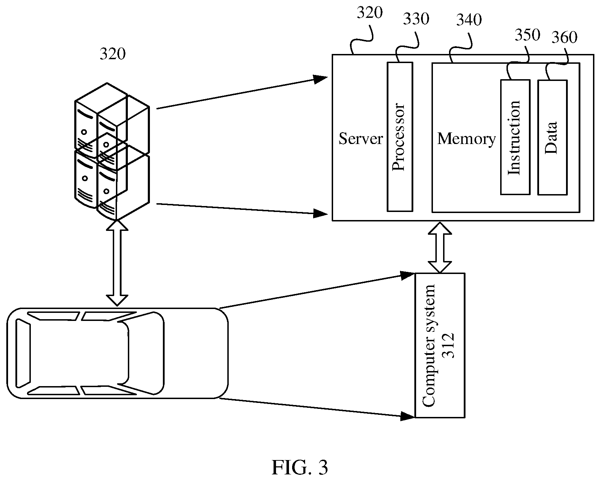

For example, as shown in FIG. 3, data from a computer system 312 may be transferred via a network to a cloud-side server 320 (which may also be referred to as a cloud) for further processing. The network and an intermediate node may include various configurations and protocols, including Internet, World Wide Web, an intranet, a virtual private network, a wide area network, a local area network, a dedicated network using a proprietary communication protocol of one or more companies, Ethernet, Wi-Fi, a hyper text transfer protocol (hyper text transfer protocol, HTTP), and various combinations thereof. Such communication may be performed by any device that can transmit data to and from other computers, such as a modem or a wireless interface. For example, data such as a vehicle state and environment information is transmitted to the server 320 on a cloud side for further processing. The server on the cloud side may identify and process the data by using a plurality of neural network models, and feed an identification result back to the computer system 312, so that the computer system 312 may determine whether to enable or disable the intelligent driving assistance function.

In an example, the server 320 may include a server such as a load balancing server cluster having a plurality of computers, and exchanges information with different nodes of the network for the purpose of receiving, processing, and transmitting data from the computer system 312. The server may be configured similar to the computer system 312, and has a processor 330, a memory 340, instructions 350, and data 360.

The intelligent driving system may include several intelligent driving assistance functions, such as pre-collision system (pre-collision system, PCS), adaptive cruise control (adaptive cruise control, ACC), lane keeping aid (lane keeping aid, LKA), cross traffic alert (cross traffic alert, CTA), rear cross traffic alert (rear cross traffic alert, RCTA), blind spot warning (blind spot warning, BSW), closed vehicle alarm, traffic jam assist (traffic jam assist, TJA).

One of key components in intelligent driving vehicles is an intelligent driving control component (for example, an advanced driving assistance system (advanced driving assistance system, ADAS) or a mobile data center (mobile data center, MDC)). The component includes an artificial intelligence (artificial intelligence, AI) control chip and a board, and is configured to control a vehicle to implement intelligent driving. A "component" in the intelligent driving control component may also be denoted as a module, a system, a component, a unit, a device, or the like. For ease of description, they are collectively referred to as components in the following.

The intelligent driving control component generates a large amount of heat during a working process thereof. In order to ensure that working performance is not affected, heat from the intelligent driving control component needs to be dissipated. Common heat dissipation modes include air cooling heat dissipation and liquid cooling heat dissipation. As a computing power requirement of the intelligent driving control component increases, a power of the intelligent driving control component becomes higher, and a heat dissipation problem of the intelligent driving control component cannot be further solved through air cooling. Therefore, liquid cooling is required for heat dissipation. Because a liquid cooling system exists in the vehicle, the intelligent driving control component may be connected to the existing liquid cooling system to implement heat dissipation of the intelligent driving control component. However, in the conventional technology, after the intelligent driving control component is connected to the existing liquid cooling system, the rotation speed of the pump is directly set to 100% of the full speed. In this case, even when heating components in the liquid cooling system are in a low power state, the pump works at full speed, which is very unfavorable to energy saving of the entire vehicle. Therefore, how to use the existing liquid cooling system to dissipate heat for intelligent driving control components and meet the energy saving requirement of the entire vehicle has become a new problem.

For the foregoing problem, this application provides a liquid cooling system. An intelligent driving control component in the liquid cooling system may participate in rotation speed control of the pump in the liquid cooling system, to meet the heat dissipation requirement of the intelligent driving control component and the energy saving requirement of the entire vehicle.

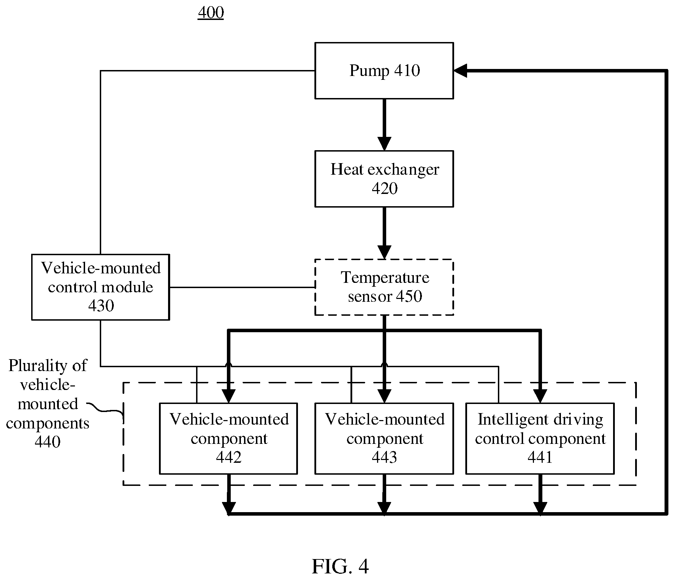

FIG. 4 is an example diagram of a system architecture of a liquid cooling system according to an embodiment of this application. It should be understood that the system architecture of the liquid cooling system shown in FIG. 4 is merely an example, and the liquid cooling system in this embodiment of this application is not limited thereto. The following describes in detail the liquid cooling system 400.

As shown in FIG. 4, the liquid cooling system 400 includes a pump 410, a heat exchanger 420, a vehicle-mounted control module 430, and a plurality of vehicle-mounted components 440. The plurality of vehicle-mounted components 440 include an intelligent driving control component 441 and other vehicle-mounted components (such as a vehicle-mounted component 442 and a vehicle-mounted component 443).

The pump 410 is configured to deliver liquid to the plurality of vehicle-mounted components 440, to dissipate heat to the plurality of vehicle-mounted components 440.

The vehicle-mounted control module 430 is configured to determine a rotation speed of the pump 410 based on pump rotation speed requirements of the plurality of vehicle-mounted components 440. It should be understood that determining the rotation speed of the pump 410 based on the pump rotation speed requirements of the plurality of vehicle-mounted components 440 is determining the rotation speed of the pump 410 based on a pump rotation speed requirement of each of the plurality of vehicle-mounted components 440.

The liquid cooling system in this embodiment of this application includes the pump, the heat exchanger, the vehicle-mounted control module, and the plurality of vehicle-mounted components. The plurality of vehicle-mounted components include the intelligent driving control component. The pump is configured to deliver liquid to the plurality of vehicle-mounted components, to dissipate heat for the plurality of vehicle-mounted components. Therefore, the liquid cooling system can implement heat dissipation for the intelligent driving control component. In addition, the vehicle-mounted control module may determine the rotation speed of the pump based on the pump rotation speed requirements of the plurality of vehicle-mounted components, so that the intelligent driving control component may participate in rotation speed control of the pump in the liquid cooling system, instead of directly using a full pump speed. In this way, heat dissipation of the intelligent driving control component is met and an energy saving requirement of the entire vehicle is met.

It should be understood that the plurality of vehicle-mounted components 440 are vehicle-mounted components that heat during operation and that need to be cooled through liquid. Therefore, in this application, the plurality of vehicle-mounted components 440 may alternatively be referred to as a plurality of to-be-liquid cooling components in a vehicle.

It should be understood that, in this embodiment of this application, the liquid cooling system may be a liquid cooling system formed by connecting the intelligent driving control component to an existing liquid cooling system in the vehicle. However, it should also be understood that this does not constitute a limitation on this application. In some cases, the liquid cooling system may alternatively be a new liquid cooling system redesigned for the intelligent driving control component or redesigned for the intelligent driving control component and other vehicle-mounted components. However, for ease of description, it is considered in the following that the liquid cooling system is a liquid cooling system formed by connecting the intelligent driving control component to the existing liquid cooling system in the vehicle. Therefore, the other vehicle-mounted components (such as the vehicle-mounted component 442 and the vehicle-mounted component 443) can be considered as existing vehicle-mounted components in the existing liquid cooling system. For example, if the existing liquid cooling system is a motor liquid cooling system, the other vehicle-mounted components may be components, for example, a motor. If the existing liquid cooling system is a battery liquid cooling system, the other vehicle-mounted components may be components, for example, a battery. This is not limited in this application.

It should be understood that in the liquid cooling system 400, there may be one or more other vehicle-mounted components. This is not limited in this application. However, for ease of description, the vehicle-mounted component 442 and the vehicle-mounted component 443 are used as examples in the following for description.

Optionally, as shown in FIG. 4, the plurality of vehicle-mounted components 440 may be separately connected to a plurality of pipelines, the plurality of pipelines are connected in parallel, and the plurality of pipelines are separately connected to the pump 410 and the heat exchanger 420 to form a circulation loop (a loop formed by an arrow connection). Optionally, the vehicle-mounted control module 430 is separately connected to the pump 410 and the plurality of vehicle-mounted components 440 by using lines.

Optionally, locations of the pump and the heat exchanger in FIG. 4 are merely examples, and constitute no limitation on this application. In an actual operation, heat exchange may be performed first, and then liquid is transmitted by using the pump. This is not limited in this application.

Optionally, the liquid cooling system 400 may further include a temperature sensor 450. The temperature sensor 450 may be located at a liquid cooling inlet of the plurality of vehicle-mounted components 440, and the temperature sensor 450 is configured to measure an inlet water temperature.

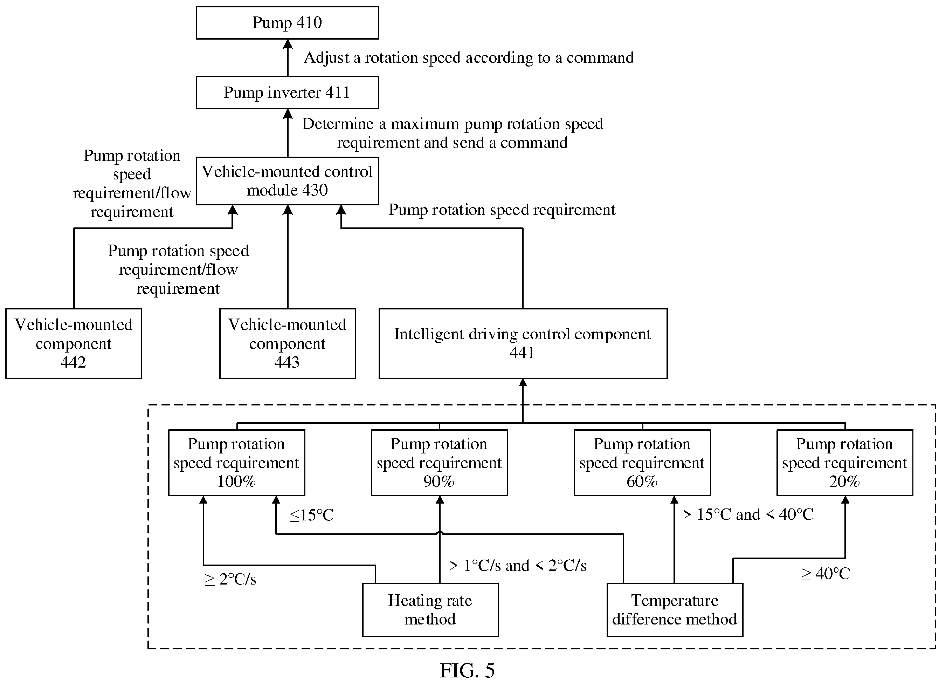

It should be understood that a rotation speed of the pump 410 may usually be adjusted through a pump frequency converter 411 (shown in FIG. 5), and therefore, the liquid cooling system 400 may further include the pump frequency converter 411, configured to adjust the rotation speed of the pump 410 as instructed by the vehicle-mounted control module 430.

It should be understood that, as mentioned above, in this application, it may be considered that the liquid cooling system 400 is a new liquid cooling system formed by connecting the intelligent driving control component 441 to the existing liquid cooling system in the vehicle. In this case, the vehicle-mounted component 442 and the vehicle-mounted component 443 in the existing liquid cooling system of the vehicle have their own set of speed adjustment policies and may provide the speed adjustment policies to the vehicle-mounted control module 430, so that the vehicle-mounted control module 430 can obtain actual heat dissipation requirements of the vehicle-mounted component 442 and the vehicle-mounted component 443. In this application, after the intelligent driving control component 441 is connected to the existing liquid cooling system, the intelligent driving control component 441 may also provide a set of speed adjustment policies for the vehicle-mounted control module 430, so that the vehicle-mounted control module 430 may simultaneously compare heat dissipation requirements from the intelligent driving control component 441, the vehicle-mounted component 442, and the vehicle-mounted component 443, and determine the rotation speed of the pump 410 based on the heat dissipation requirements of the foregoing three components. In this way, the pump 410 can adjust the speed and save energy in a low power state, and the pump 410 can adjust the speed and dissipate heat in a high power state. It should be understood that, in this application, the heat dissipation requirement provided by each component may be a flow requirement or a pump rotation speed requirement, and the flow requirement or the pump rotation speed requirement may also be understood as a liquid flow or a pump rotation speed required for implementing heat dissipation. It should be understood that, generally, if the requirement provided by the component is the flow requirement, the vehicle-mounted control module 430 further needs to convert the flow requirement into a corresponding pump rotation speed requirement.

Therefore, determining the rotation speed of the pump 410 based on the heat dissipation requirements of the three components may specifically be determining the rotation speed of the pump 410 based on the pump rotation speed requirements of the three components.

Optionally, the vehicle-mounted control module 430 may further determine the rotation speed of the pump 410 based on a largest value of the pump rotation speed requirements of the plurality of vehicle-mounted components 440, so that the rotation speed of the pump can meet heat dissipation of the plurality of vehicle-mounted components simultaneously.

Optionally, for the existing vehicle-mounted component 442 and vehicle-mounted component 443, because the vehicle-mounted component 442 and the vehicle-mounted component 443 have limited computing power, flow requirements of the vehicle-mounted component 442 and the vehicle-mounted component 443 may usually be provided to the vehicle-mounted control module 430, and then the vehicle-mounted control module 430 determines, through calculation, pump rotation speed requirements of the vehicle-mounted component 442 and the vehicle-mounted component 443. However, for the intelligent driving control component 441, because the intelligent driving control component 441 has strong computing power, the pump rotation speed requirement may be directly calculated and provided to the vehicle-mounted control module 430. Alternatively, a flow requirement may be first provided, and then converted into the pump rotation speed requirement through the vehicle-mounted control module 430. This is not limited in this application.

A manner of determining the pump rotation speed requirements of the plurality of vehicle-mounted components 440 will be described in detail below.

It should be understood that, at a fixed inlet water temperature, a pump rotation speed requirement and a flow requirement are in a one-to-one correspondence. The flow requirement may be determined by each vehicle-mounted component based on a temperature of each vehicle-mounted component and the inlet water temperature. This is not limited in this application. Therefore, optionally, a pump rotation speed requirement of each of the plurality of vehicle-mounted components 440 may be determined based on the inlet water temperature and the flow requirement of each vehicle-mounted component.

Table 1 shows a correspondence among an inlet water temperature, a flow requirement, and a pump rotation speed requirement of each vehicle-mounted component. It should be understood that Table 1 is merely used as an example, and does not constitute a limitation on this application.

Optionally, Table 1 may be embedded in the vehicle-mounted control module 430, so that the vehicle-mounted control module 430 correspondingly obtains the pump rotation speed requirement of each component after obtaining the flow requirement of each vehicle-mounted component. The following describes this example in detail with reference to Table 1.

As shown in Table 1, at a fixed inlet water temperature, there is a corresponding pump rotation speed requirement for the flow requirement of each vehicle-mounted component. For example, if the vehicle-mounted control module 430 detects that the inlet water temperature is 40°C at this time, and simultaneously receives the flow requirements of the intelligent driving control component 441, the vehicle-mounted component 442, and the vehicle-mounted component 443, which are respectively 3 L/min, 4 L/min, and 2 L/min, the vehicle-mounted control module 430 may calculate, according to Table 1, that the pump rotation speed requirements of the intelligent driving control component 441, the vehicle-mounted component 442, and the vehicle-mounted component 443 are 90%, 60%, and 60% respectively. The pump speed can be adjusted based on the largest pump rotation speed requirement (90%).

**Table 1**

| Inlet water temperature (°C) | Flow requirement (L/min) of the intelligent driving control component 441 | Flow requirement (L/min) of the vehicle-mounted component 442 | Flow requirement (L/min) of the vehicle-mounted component 443 | Pump rotation speed requirement (%) |
|---|---|---|---|---|
| 60 | 5 | 10 | 8 | 90 |
| 60 | 3 | 6 | 4 | 60 |
| 60 | 1 | 3 | 2 | 20 |
| 50 | 4 | 8 | 6 | 90 |
| 50 | 2 | 5 | 3 | 60 |
| 50 | 0.5 | 2 | 1 | 20 |
| 40 | 3 | 7 | 5 | 90 |
| 40 | 1.5 | 4 | 2 | 60 |
| 40 | 0.4 | 1.5 | 0.8 | 20 |

It should be understood that, if a flow requirement value of a vehicle-mounted component exceeds a flow value that can be provided by the pump rotation speed (90%) in the query table, it may be considered that the pump rotation speed requirement of the vehicle-mounted component is a full pump speed, and further, the pump speed may be adjusted based on the full pump speed. For example, if the vehicle-mounted control module 430 detects that the inlet water temperature is 60°C at this time, and simultaneously receives the flow requirements of the intelligent driving control component 441, the vehicle-mounted component 442, and the vehicle-mounted component 443, which are respectively 6 L/min, 10 L/min, and 7 L/min, the vehicle-mounted control module 430 calculates that the pump rotation speed requirements of the intelligent driving control component 441, the vehicle-mounted component 442, and the vehicle-mounted component 443 are "> 90%", "90%", and "> 60% and < 90%" respectively. The pump speed can be adjusted based on the full pump speed (100%).

In addition, the pump rotation speed requirement of the intelligent driving control component 441 may not be determined in the foregoing manner, but is determined by the intelligent driving control component 441 and provided to the vehicle-mounted control module 430. In this case, the vehicle-mounted control module 430 may directly compare the pump rotation speed requirement provided by the intelligent driving control component 441 with the pump rotation speed requirements of the vehicle-mounted component 442 and the vehicle-mounted component 443 that are obtained in Table 1.

Optionally, the intelligent driving control component 441 may determine the pump rotation speed requirement of the intelligent driving control component 441 in one or any combination of the following three manners.

Manner 1: Determined based on the inlet water temperature.

It should be understood that, different from the manner shown in Table 1, in the manner 1, a smallest flow required when the intelligent driving control component 441 works at a full power may be determined based on only the inlet water temperature, and a required pump rotation speed requirement may be simultaneously calculated.

Optionally, the vehicle-mounted control module 430 may query the temperature sensor 450 for the inlet water temperature in this case, and notify the intelligent driving control component 441 of the inlet water temperature, or the driving control component 441 may directly collect the inlet water temperature from the temperature sensor 450. This is not limited in this application.

Optionally, the pump rotation speed requirement of the intelligent driving control component 441 may be further determined based on a temperature range in which the inlet water temperature falls.

Specifically, the foregoing calculation method may be built in the vehicle-mounted control module 430 or the intelligent driving control component 441 through the query table. For example, Table 2 shows a correspondence between an inlet water temperature and a pump rotation speed requirement. It can be learned from Table 2 that, if Tᵢₙ ≥ 60°C, a corresponding pump rotation speed requirement of the intelligent driving control component 441 is 100%. If 40°C ≤ Tᵢₙ < 60°C, a corresponding pump rotation speed requirement of the intelligent driving control component 441 is 90%. If 20°C ≤ Tᵢₙ < 40°C, a corresponding pump rotation speed requirement of the intelligent driving control component 441 is 60%. If Tᵢₙ < 20°C, a pump corresponding rotation speed requirement of the intelligent driving control component 441 is 20%. Therefore, after the inlet water temperature is obtained, the pump rotation speed requirement may be obtained by querying Table 2 based on the temperature range in which the inlet water temperature falls.

**Table 2**

| Inlet water temperature Tᵢₙ | Pump rotation speed requirement |
|---|---|
| ≥ 60°C | 100% |
| 40°C ≤ Tᵢₙ < 60°C | 90% |
| 20°C ≤ Tᵢₙ < 40°C | 60% |
| < 20°C | 20% |

Manner 2: Determined based on a junction temperature of a core chip on the intelligent driving control component 441.

It should be understood that the junction temperature is an actual operating temperature of a semiconductor in the electronic device.

In this manner, the pump rotation speed requirement may be calculated based on the junction temperature, which is obtained by monitoring the junction temperature of the core chip on the intelligent driving control component 441.

Optionally, the pump rotation speed requirement may be further determined based on a temperature range in which the junction temperature of the core chip on the intelligent driving control component 440 falls.

Specifically, the calculation method may be built in the vehicle-mounted control module 430 or the intelligent driving control component 441 through the query table. For example, Table 3 shows a correspondence between a junction temperature of a core chip and a pump rotation speed requirement. It can be learned from Table 3 that, if Tⱼ ≥ 95°C, a corresponding pump rotation speed requirement of the intelligent driving control component 441 is 100%. If 65°C < Tⱼ < 95°C, a corresponding pump rotation speed requirement of the intelligent driving control component 441 is 60%. If Tⱼ ≤ 65°C, a corresponding pump rotation speed requirement of the intelligent driving control component 441 is 20%. In this way, after the junction temperature of the core chip is obtained, the pump rotation speed requirement may be obtained by querying Table 3 based on a temperature range in which the junction temperature of the core chip falls.

**Table 3**

| Junction temperature Tⱼ of the core chip | Pump rotation speed requirement |
|---|---|
| ≥ 95°C | 100% |
| 65°C < Tⱼ < 95°C | 60% |
| ≤ 65°C | 20% |

Manner 3: Optionally, in the manner 3, the pump rotation speed requirement of the intelligent driving control component 441 may be determined based on temperature differences at the plurality of locations on the intelligent driving control component 441.

The temperature difference is a difference between a temperature specification and an actual temperature. It means that the pump rotation speed requirement of the intelligent driving control component 441 can be determined based on the difference between the temperature specification and the actual temperature at each of the plurality of locations.

Specifically, temperature information that is reported by the temperature sensor and that is about the plurality of locations on the intelligent driving control component 441 may be first obtained. The plurality of locations refer to locations where a plurality of components, such as a key chip and a board, are located. In addition, a calculation table may be built in to provide all temperatures reported by the temperature sensor and temperature specifications of corresponding locations (that is, temperatures that can be borne by current locations). A difference (denoted as a GAP value) between a real-time reported temperature reported by a temperature sensor and a temperature specification is calculated, as shown in Table 4.

**Table 4**

| Location | Temperature specification at a corresponding location | Real-time reported temperature | Temperature difference |
|---|---|---|---|
| A | 125°C | 100°C | 25°C |
| B | 105°C | 90°C | 15°C |
| C | 100°C | 90°C | 10°C |
| D | 110°C | 100°C | 10°C |
| E | 95°C | 90°C | 5°C |

Optionally, after the temperature differences at the plurality of locations are obtained, the pump rotation speed requirement may be determined based on a smallest value of the temperature differences at the plurality of locations.

Optionally, the pump rotation speed requirement may be determined based on a temperature range in which the smallest value of the temperature differences at the plurality of locations on the intelligent driving control component falls.

Specifically, it may also be implemented by using a built-in query table. For example, Table 5 shows a correspondence between a smallest value of the temperature differences at the plurality of locations and the pump rotation speed requirement. It can be learned from Table 3 that, if GAPₘᵢₙ ≤ 15°C, a corresponding pump rotation speed requirement of the intelligent driving control component 441 is 100%. If 15 < GAPₘᵢₙ < 40°C, a pump corresponding rotation speed requirement of the intelligent driving control component 441 is 60%. If GAPₘᵢₙ ≥ 40°Cₘᵢₙ, a corresponding pump rotation speed requirement of the intelligent driving control component 441 is 20%. GAPₘᵢₙ refers to the smallest value of the temperature differences. Therefore, after the smallest value of the temperature differences at the plurality of locations is obtained, the pump rotation speed requirement may be obtained by querying Table 5 based on the temperature range in which the smallest value of the temperature differences at the plurality of locations falls. The pump rotation speed requirement determined according to this manner can ensure that a liquid flow provided at any water temperature and any power consumption meets a heat dissipation requirement in this state.

**Table 5**

| GAPₘᵢₙ value | Pump rotation speed requirement |
|---|---|
| ≤ 15°C | 100% |
| 15°C < GAP min < 40°C | 60% |
| ≥ 40°C | 20% |

Optionally, when determining the pump rotation speed requirement based on the GAPₘᵢₙ value, the intelligent driving control component 441 may further determine the pump rotation speed requirement with reference to the heating rates at the plurality of locations.

Specifically, the pump rotation speed requirement may be determined with reference to a largest value of the heating rates at the plurality of locations on the intelligent driving control component 441.

When the pump rotation speed requirement is determined based on the GAPₘᵢₙ value and the largest value of the heating rates at the plurality of locations, the pump rotation speed requirement may be determined based on a larger one of a first pump rotation speed requirement and a second pump rotation speed requirement, where the first pump rotation speed requirement is determined based on the smallest value of the temperature differences at the plurality of locations on the intelligent driving control component. The second pump rotation speed requirement is determined based on the largest value of the heating rates at the plurality of locations on the intelligent driving control component.

Further, the first pump rotation speed requirement may be determined based on a temperature range in which the smallest value of the temperature differences at the plurality of locations on the intelligent driving control component 441 falls, and/or the second pump rotation speed requirement may be determined based on a rate range in which the largest value of the heating rates at the plurality of locations on the intelligent driving control component 441 falls.

That the pump rotation speed requirement (that is, the first pump rotation speed requirement) is determined based on the temperature range in which the smallest value of the temperature differences at the plurality of locations on the intelligent driving control component 441 falls has been described in the foregoing Table 5. Details are not described herein again.

With reference to Table 6, that the second pump rotation speed requirement is determined based on a rate range in which the largest value of the heating rates at the plurality of locations on the intelligent driving control component falls is described in the following. Specifically, a specific determining manner may alternatively be implemented by using a built-in query table. For example, Table 6 shows a correspondence between a largest value of the heating rates at the plurality of locations and a pump rotation speed requirement. It can be learned from Table 6 that, if T_{S-max} ≥ 2°C/s, a corresponding pump rotation speed requirement of the intelligent driving control component 441 is 100%. If 1°C/s < T_{S-max} < 2°C/s, a corresponding pump rotation speed requirement of the intelligent driving control component 441 is 90%. If T_{S-max} ≤ 1°C/s, the pump rotation speed requirement of the intelligent driving control component 441 is not reported. In this way, after the largest value of the heating rates at the plurality of locations is obtained, the pump rotation speed requirement may be obtained by querying Table 6 based on the rate range in which the largest value of the heating rates at the plurality of locations falls. Therefore, when the power of the intelligent driving control component 441 increases sharply, the pump can be adjusted in time, to implement heat dissipation.

**Table 6**

| Heating rate T_{S-max} | Pump rotation speed requirement |
|---|---|
| ≥ 2°C/s | 100% |
| 1°C/s < Ts-max < 2°C/s | 90% |
| ≤ 1°C/s | No reporting |

It should be understood that, in an actual operation process, the heating rate may be calculated once per second. If a related threshold in Table 6 is reached through three consecutive calculations, a corresponding pump rotation speed requirement is executed.

In this embodiment, the pump rotation speed requirement of the intelligent driving control component is determined by the larger of the pump rotation speed requirement determined based on the smallest value of the temperature differences at the plurality of locations on the intelligent driving control component and the pump rotation speed requirement determined based on the largest value of the heating rates at the plurality of locations on the intelligent driving control component. Therefore, when the heating rates are high, the pump rotation speed requirement determined by the heating rate can be used to control the pump to adjust the speed. When the heating rates are low, the pump rotation speed requirement determined by the temperature difference can be used to control the pump to adjust the speed. Further, the pump rotation speed requirement can simultaneously meet heat dissipation requirements at the different locations on the intelligent driving control component, and the pump rotation speed can be adjusted in time to perform heat dissipation when powers of some locations increase sharply.

It should be understood that the manner 3 may also be applied to another type of device, provided that the another type of device has temperature monitoring points at a plurality of key locations at the same time. This is not limited in this application.

The liquid cooling system and various implementations of this application are described in detail above. The following briefly describes a preferred control policy in this application with reference to FIG. 5. In a preferred manner, FIG. 5 is an example diagram of a pump rotation speed control policy applied to a liquid cooling system according to an embodiment of this application.

As shown in FIG. 5, in actual working of the liquid cooling system, a calculator of the intelligent driving control component 441 may determine a pump rotation speed requirement of the intelligent driving control component 441 based on a temperature difference algorithm and a heating rate algorithm. For a specific determining manner, refer to the foregoing manner 3. Details are not described herein again.

The other vehicle-mounted components 442 and 443 may determine their own flow requirements or pump rotation speed requirements according to their own speed adjustment policies. For details, refer to Table 1.

The vehicle-mounted control module 430 simultaneously obtains the requirements of components, determines a largest pump rotation speed requirement from the requirements, and sends a speed adjustment instruction to the pump frequency converter 411.

After receiving the speed adjustment instruction, the pump frequency converter 411 controls the pump 410, according to the instruction, to adjust the rotation speed based on the largest pump rotation speed requirement.

According to the speed adjustment policy in this embodiment, the intelligent driving control component can participate in speed adjustment of the pump in the liquid cooling system, to meet a heat dissipation requirement of the intelligent driving control component and an energy saving requirement of the entire vehicle. In addition, when the power of the intelligent driving control component changes abruptly, the liquid cooling system can also respond in time to heat dissipation of the intelligent driving control component, to ensure normal operation of the intelligent driving control component.

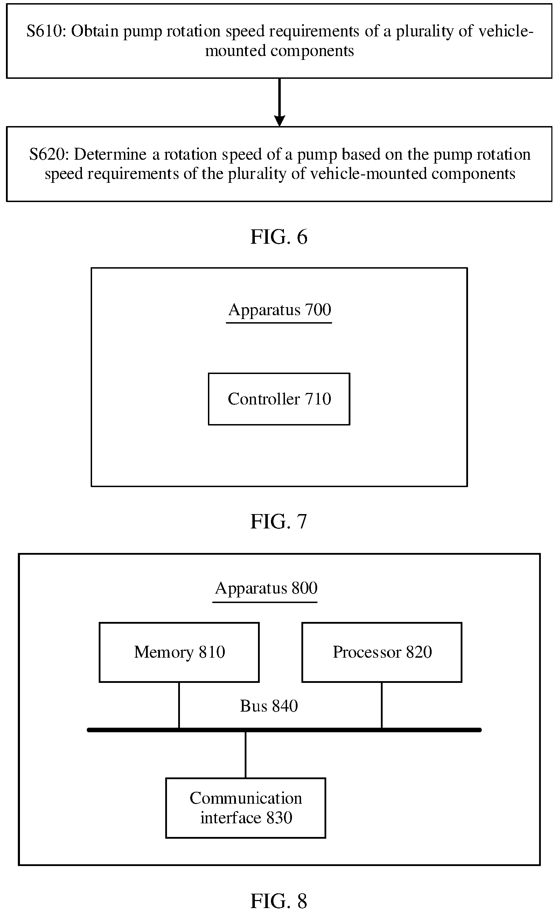

FIG. 6 is an example diagram of a control method applied to a liquid cooling system according to an embodiment of this application. The liquid cooling system may be the liquid cooling system 400 in FIG. 4. The liquid cooling system includes a pump, a heat exchanger and a plurality of vehicle-mounted components, where the plurality of vehicle-mounted components include an intelligent driving control component. The pump is configured to deliver liquid to the plurality of vehicle-mounted components, to dissipate heat for the plurality of vehicle-mounted components. A control method 600 includes step S610 and step S620. The following describes these steps in detail.

S610: Obtain pump rotation speed requirements of a plurality of vehicle-mounted components.

S620: Determine a rotation speed of a pump based on the pump rotation speed requirements of the plurality of vehicle-mounted components.

Optionally, determining the rotation speed of the pump based on the pump rotation speed requirements of the plurality of vehicle-mounted components includes: determining the rotation speed of the pump based on a largest value of the pump rotation speed requirements of the plurality of vehicle-mounted components.

Optionally, the control method 600 may further include: determining the pump rotation speed requirements of the plurality of vehicle-mounted components based on an inlet water temperature and a flow requirement of each of the plurality of vehicle-mounted components.

Optionally, the control method 600 may further include: determining a pump rotation speed requirement of the intelligent driving control component based on temperature differences at the plurality of locations on the intelligent driving control component, where the temperature difference is a difference between a temperature specification and an actual temperature.

Optionally, the determining a pump rotation speed requirement of the intelligent driving control component based on temperature differences at the plurality of locations on the intelligent driving control component includes: determining the pump rotation speed requirement of the intelligent driving control component based on a smallest value of the temperature differences at the plurality of locations on the intelligent driving control component.

Optionally, the determining the pump rotation speed requirement of the intelligent driving control component based on a smallest value of the temperature differences at the plurality of locations on the intelligent driving control component includes: determining a temperature range in which the smallest value of the temperature differences at the plurality of locations on the intelligent driving control component falls; and determining the pump rotation speed requirement of the intelligent driving control component based on the temperature range in which the smallest value of temperature differences at the plurality of locations on the intelligent driving control component falls.

Optionally, the control method 600 further includes: determining the pump rotation speed requirement of the intelligent driving control component based on temperature differences and heating rates at the plurality of locations on the intelligent driving control component, where the temperature difference is a difference between a temperature specification and an actual temperature.

Optionally, the determining the pump rotation speed requirement of the intelligent driving control component based on temperature differences and heating rates at the plurality of locations on the intelligent driving control component includes: determining the pump rotation speed requirement of the intelligent driving control component based on a smallest value of the temperature differences and a largest value of the heating rates at the plurality of locations on the intelligent driving control component.

Optionally, the determining the pump rotation speed requirement of the intelligent driving control component based on a smallest value of the temperature differences and a largest value of the heating rates at the plurality of locations on the intelligent driving control component includes: determining a first pump rotation speed requirement based on the smallest value of the temperature differences at the plurality of locations on the intelligent driving control component; determining a second pump rotation speed requirement based on a largest value of the heating rates at the plurality of locations on the intelligent driving control component; and determining the pump rotation speed requirement of the intelligent driving control component based on a larger one of the first pump rotation speed requirement and the second pump rotation speed requirement.

Optionally, the determining a first pump rotation speed requirement based on the smallest value of the temperature differences at the plurality of locations on the intelligent driving control component includes: determining a temperature range in which the smallest value of the temperature differences at the plurality of locations on the intelligent driving control component falls, and determining the first pump rotation speed requirement based on the temperature range in which the smallest value of the temperature differences at the plurality of locations on the intelligent driving control component falls; and/or the determining a second pump rotation speed requirement based on a largest value of the heating rates at the plurality of locations on the intelligent driving control component includes: determining a rate range in which the largest value of the heating rates at the plurality of locations on the intelligent driving control component falls, and determining the second pump rotation speed requirement based on the rate range in which the largest value of the heating rates at the plurality of locations on the intelligent driving control component falls.

Optionally, the control method 600 further includes: determining the pump rotation speed requirement of the intelligent driving control component based on the inlet water temperature.

Optionally, the determining the pump rotation speed requirement of the intelligent driving control component based on the inlet water temperature includes: determining a temperature range in which the inlet water temperature falls; and determining the pump rotation speed requirement of the intelligent driving control component based on the temperature range in which the inlet water temperature falls.

Optionally, the control method 600 further includes: determining the pump rotation speed requirement of the intelligent driving control component based on a junction temperature of a core chip on the intelligent driving control component.

Optionally, the determining the pump rotation speed requirement of the intelligent driving control component based on a junction temperature of a core chip on the intelligent driving control component includes: determining a temperature range in which the junction temperature of the core chip on the intelligent driving control component falls; and determining the pump rotation speed requirement of the intelligent driving control component based on the temperature range in which the junction temperature of the core chip on the intelligent driving control component falls.

It should be understood that, in actual operation, the foregoing control method may be performed by one control apparatus (which is also referred to as a controller, a control module, a control unit, or the like), or may be jointly performed by a plurality of control apparatuses. This is not limited in this application.

FIG. 7 is an example diagram of a control apparatus applied to a liquid cooling system according to an embodiment of this application. It should be understood that the apparatus 700 shown in FIG. 7 may be applied to a liquid cooling system. The liquid cooling system includes a pump, a heat exchanger, and a plurality of vehicle-mounted components. The plurality of vehicle-mounted components include an intelligent driving control component. The pump is configured to deliver liquid to the plurality of vehicle-mounted components, to dissipate heat for the plurality of vehicle-mounted components.

The control apparatus 700 includes a controller 710, and the controller 710 is configured to obtain pump rotation speed requirements of the plurality of vehicle-mounted components; and determine a rotation speed of the pump based on the pump rotation speed requirements of the plurality of vehicle-mounted components.

Optionally, the controller 710 may be further configured to determine the rotation speed of the pump based on a largest value of the pump rotation speed requirements of the plurality of vehicle-mounted components.

Optionally, the controller 710 may be further configured to determine the pump rotation speed requirements of the plurality of vehicle-mounted components based on an inlet water temperature and a flow requirement of each of the plurality of vehicle-mounted components.

Optionally, the controller 710 may be further configured to determine the pump rotation speed requirement of the intelligent driving control component based on temperature differences at a plurality of locations on the intelligent driving control component, where the temperature difference is a difference between a temperature specification and an actual temperature.

Optionally, the controller 710 may be further configured to determine the pump rotation speed requirement of the intelligent driving control component based on a smallest value of the temperature differences at the plurality of locations on the intelligent driving control component.

Optionally, the controller 710 may be further configured to determine a temperature range in which the smallest value of the temperature differences at the plurality of locations on the intelligent driving control component falls; and determine the pump rotation speed requirement of the intelligent driving control component based on the temperature range in which the smallest value of the temperature differences at the plurality of locations on the intelligent driving control component falls.

Optionally, the controller 710 may be further configured to determine a pump rotation speed requirement of the intelligent driving control component based on temperature differences and heating rates at a plurality of locations on the intelligent driving control component, where the temperature difference is a difference between a temperature specification and an actual temperature.

Optionally, the controller 710 may be further configured to determine the pump rotation speed requirement of the intelligent driving control component based on a smallest value of the temperature differences and a largest value of the heating rates at the plurality of locations on the intelligent driving control component.

Optionally, the controller 710 may be further configured to determine a first pump rotation speed requirement based on the smallest value of the temperature differences at the plurality of locations on the intelligent driving control component; determine a second pump rotation speed requirement based on the largest value of the heating rates at the plurality of locations on the intelligent driving control component; and determine the pump rotation speed requirement of the intelligent driving control component based on a larger one of the first pump rotation speed requirement and the second pump rotation speed requirement.

Optionally, the controller 710 may be further configured to determine a temperature range in which the smallest value of the temperature differences at the plurality of locations on the intelligent driving control component falls; and determine the first pump rotation speed requirement based on the temperature range in which the smallest value of the temperature differences at the plurality of locations on the intelligent driving control component falls.

Optionally, the controller 710 may be further configured to determine a rate range in which the largest value of the heating rates at the plurality of locations on the intelligent driving control component falls; and determine the second pump rotation speed requirement based on the rate range in which the largest value of the heating rates at the plurality of locations on the intelligent driving control component falls.

Optionally, the controller 710 may be further configured to determine the pump rotation speed requirement of the intelligent driving control component based on the inlet water temperature.

Optionally, the controller 710 may be further configured to determine a temperature range in which the inlet water temperature falls; and determine the pump rotation speed requirement of the intelligent driving control component based on the temperature range in which the inlet water temperature falls.

Optionally, the controller 710 may be further configured to determine the pump rotation speed requirement of the intelligent driving control component based on a junction temperature of a core chip on the intelligent driving control component.

Optionally, the controller 710 may be further configured to determine a temperature range in which the junction temperature of the core chip on the intelligent driving control component falls; and determine the pump rotation speed requirement of the intelligent driving control component based on the temperature range in which the junction temperature of the core chip on the intelligent driving control component falls.

FIG. 8 is an example block diagram of a hardware structure of a vehicle control apparatus according to an embodiment of this application. This apparatus 800 (the apparatus 800 may be specifically a computer device) includes a memory 810, a processor 820, a communication interface 830, and a bus 840. Communication connections between the memory 810, the processor 820, and the communication interface 830 are implemented through the bus 840.

The memory 810 may be a read only memory (read only memory, ROM), a static storage device, a dynamic storage device, or a random access memory (random access memory, RAM). The memory 810 may store a program. When executing the program stored in the memory 810, the processor 820 is configured to perform steps of the control method in embodiments of this application.

The processor 820 may use a general-purpose central processing unit (central processing unit, CPU), a microprocessor, an application-specific integrated circuit (application-specific integrated circuit, ASIC), a graphics processing unit (graphics processing unit, GPU), or one or more integrated circuits, and is configured to execute a related program, to implement the control method in method embodiments of this application.

The processor 820 may be an integrated circuit chip and has a signal processing capability. In an implementation process, the steps of the control method in this application may be completed by using a hardware integrated logic circuit or software instructions in the processor 820.

The processor 820 may alternatively be a general-purpose processor, a digital signal processor (digital signal processor, DSP), an application-specific integrated circuit (ASIC), a field programmable gate array (field programmable gate array, FPGA) or another programmable logic device, a discrete gate or transistor logic device, or a discrete hardware component. It may implement or perform the methods, the steps, and logical block diagrams that are disclosed in embodiments of this application. The general-purpose processor may be a microprocessor, or the processor may be any conventional processor or the like. Steps of the methods disclosed with reference to embodiments of this application may be directly executed and accomplished through a hardware decoding processor, or may be executed and accomplished by using a combination of hardware and software modules in the decoding processor. A software module may be located in a mature storage medium in the art, such as a random access memory, a flash memory, a read-only memory, a programmable read-only memory, an electrically erasable programmable memory, or a register. The storage medium is located in the memory 810. The processor 820 reads information in the memory 810, and completes, in combination with hardware of the processor 820, a function that needs to be executed by a module included in the control apparatus in this embodiment of this application, or performs the control method in method embodiments of this application.

The communication interface 830 uses, for example but not limited to, a transceiver apparatus of a transceiver type, to implement communication between the apparatus 800 and another device or a communication network.

The bus 840 may include a channel on which information is transmitted between the components (for example, the memory 810, the processor 820, and the communication interface 830) of the apparatus 800.

An embodiment of this application further provides a vehicle. Optionally, the vehicle includes modules configured to perform any one of the foregoing control methods; and/or includes any one of the foregoing liquid cooling systems; and/or any one of the foregoing control apparatuses.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Therefore, the protection scope of this application shall be subject to the protection scope of the claims.

## Claims

1. A liquid cooling system (400), wherein the liquid cooling system (400) comprises a pump (410), a heat exchanger (420), a vehicle-mounted control module (430), and a plurality of vehicle-mounted components (440, 442, 443), wherein the plurality of vehicle-mounted components (440, 442, 443) comprise an intelligent driving control component (440, 441);
the pump (410) is configured to deliver liquid to the plurality of vehicle-mounted components (440, 442, 443), to dissipate heat for the plurality of vehicle-mounted components (440, 442, 443); and
the vehicle-mounted control module (430) is configured to determine a rotation speed of the pump (410) based on pump rotation speed requirements of the plurality of vehicle-mounted components (440, 442, 443); and
wherein a pump rotation speed requirement of the intelligent driving control component (440, 441) is determined based on temperature differences at a plurality of locations on the intelligent driving control component (440, 441), and each temperature difference is a difference between a temperature specification and an actual temperature.

2. The liquid cooling system (400) according to claim 1, wherein the vehicle-mounted control module (430) is further configured to determine the rotation speed of the pump (410) based on a largest value of the pump rotation speed requirements of the plurality of vehicle-mounted components (440, 442, 443).

3. The liquid cooling system (400) according to claim 1 or 2, wherein a pump rotation speed requirement of each of the plurality of vehicle-mounted components (440, 442, 443) is determined based on an inlet water temperature and a flow requirement of each vehicle-mounted component (440, 442, 443).

4. The liquid cooling system (400) according to claim 3, wherein the plurality of vehicle-mounted components (440, 442, 443) are respectively connected to a plurality of pipelines, the plurality of pipelines are connected in parallel, the plurality of pipelines are respectively connected to the pump (410) and the heat exchanger (420) to form a circulation loop, and the vehicle-mounted control module (430) is separately connected to the pump (410) and the plurality of vehicle-mounted components (440, 442, 443) through lines.

5. The liquid cooling system (400) according to claim 3 or 4, wherein the liquid cooling system (400) further comprises a temperature sensor (450), the temperature sensor (450) is located at a liquid cooling inlet of the plurality of vehicle-mounted components (440, 442, 443), and the temperature sensor (450) is configured to measure the inlet water temperature.

6. The liquid cooling system (400) according to claim 1, wherein the pump rotation speed requirement of the intelligent driving control component (440, 441) is determined based on a smallest value of the temperature differences at the plurality of locations on the intelligent driving control component (440, 441).

7. A control method (600) applied to a liquid cooling system (400), wherein the liquid cooling system (400) comprises a pump (410), a heat exchanger (420), and a plurality of vehicle-mounted components (440, 442, 443), the plurality of vehicle-mounted components (440, 442, 443) comprise an intelligent driving control component (440, 441), and the pump (410) is configured to deliver liquid to the plurality of vehicle-mounted components (440, 442, 443), to dissipate heat for the plurality of vehicle-mounted components (440, 442, 443); and
the control method (600) comprises:
obtaining pump rotation speed requirements of the plurality of vehicle-mounted components (440, 442, 443); and
determining a rotation speed of the pump (410) based on the pump rotation speed requirements of the plurality of vehicle-mounted components (440, 442, 443); and
determining a pump rotation speed requirement of the intelligent driving control component (440, 441) based on temperature differences at a plurality of locations on the intelligent driving control component (440, 441), wherein each temperature difference is a difference between a temperature specification and an actual temperature;
wherein determining a pump rotation speed requirement of the intelligent driving control component (440, 441) based on temperature differences at a plurality of locations on the intelligent driving control component (440, 441) comprises:
determining the pump rotation speed requirement of the intelligent driving control component (440, 441) based on a smallest value of the temperature differences at the plurality of locations on the intelligent driving control component (440, 441).

8. The control method (600) according to claim 7, wherein the determining a rotation speed of the pump (410) based on the pump rotation speed requirements of the plurality of vehicle-mounted components (440, 442, 443) comprises:
determining the rotation speed of the pump (410) based on a largest value of the pump rotation speed requirements of the plurality of vehicle-mounted components (440, 442, 443).

9. The control method (600) according to claim 7 or 8, wherein the control method (600) further comprises:
determining the pump rotation speed requirements of the plurality of vehicle-mounted components (440, 442, 443) based on an inlet water temperature and a flow requirement of each of the plurality of vehicle-mounted components (440, 442, 443).

10. The control method (600) according to claim 7, wherein determining the pump rotation speed requirement of the intelligent driving control component (440, 441) based on a smallest value of the temperature differences at the plurality of locations on the intelligent driving control component (440, 441) comprises:
determining a temperature range in which the smallest value of the temperature differences at the plurality of locations on the intelligent driving control component (440, 441) falls; and
determining the pump rotation speed requirement of the intelligent driving control component (440, 441) based on the temperature range in which the smallest value of the temperature differences at the plurality of locations on the intelligent driving control component (440, 441) falls.

11. The control method (600) according to any one of claims 7 to 9, wherein the control method (600) further comprises:
determining a pump rotation speed requirement of the intelligent driving control component (440, 441) based on the temperature differences and heating rates at the plurality of locations on the intelligent driving control component (440, 441), wherein each temperature difference is a difference between a temperature specification and an actual temperature.

12. A control apparatus (700) applied to a liquid cooling system (400) according to one or more of claims 1 to 6, comprising an input/output interface, a processor (103, 113, 330, 820), and a memory (114, 135, 340, 810), wherein the processor (103, 113, 330, 820) is configured to control the input/output interface to receive or send a signal or information, the memory (114, 135, 340, 810) is configured to store a computer program, and the processor (103, 113, 330, 820) is configured to invoke and run the computer program from the memory (114, 135, 340, 810), so that the control apparatus (700) causes the liquid cooling system to perform the control method (600) according to any one of claims 7 to 11.

## Patentansprüche

1. Flüssigkeitskühlsystem (400), wobei das Flüssigkeitskühlsystem (400) eine Pumpe (410), einen Wärmetauscher (420), ein fahrzeugmontiertes Steuerungsmodul (430) und eine Vielzahl von fahrzeugmontierten Komponenten (440, 442, 443) umfasst, wobei die Vielzahl von fahrzeugmontierten Komponenten (440, 442, 443) eine intelligente Antriebssteuerungskomponente (440, 441) umfasst;
wobei die Pumpe (410) dazu konfiguriert ist, eine Flüssigkeit an die Vielzahl von fahrzeugmontierten Komponenten (440, 442, 443) zu liefern, um Wärme für die Vielzahl von fahrzeugmontierten Komponenten (440, 442, 443) abzuführen; und wobei das fahrzeugmontierte Steuerungsmodul (430) dazu konfiguriert ist, eine Drehzahl der Pumpe (410) basierend auf Pumpendrehzahlanforderungen der Vielzahl von fahrzeugmontierten Komponenten (440, 442, 443) zu bestimmen; und
wobei eine Pumpendrehzahlanforderung der intelligenten Antriebssteuerungskomponente (440, 441) basierend auf Temperaturdifferenzen an einer Vielzahl von Stellen auf der intelligenten Antriebssteuerungskomponente (440, 441) bestimmt wird und jede Temperaturdifferenz eine Differenz zwischen einer Temperaturangabe und einer tatsächlichen Temperatur ist.

2. Flüssigkeitskühlsystem (400) nach Anspruch 1, wobei das fahrzeugmontierte Steuerungsmodul (430) ferner dazu konfiguriert ist, die Drehzahl der Pumpe (410) basierend auf einem größten Wert der Pumpendrehzahlanforderungen der Vielzahl von fahrzeugmontierten Komponenten (440, 442, 443) zu bestimmen.

3. Flüssigkeitskühlsystem (400) nach Anspruch 1 oder 2, wobei eine Pumpendrehzahlanforderung jeder der Vielzahl von fahrzeugmontierten Komponenten (440, 442, 443) basierend auf einer Einlasswassertemperatur und einer Durchflussanforderung jeder fahrzeugmontierten Komponente (440, 442, 443) bestimmt wird.

4. Flüssigkeitskühlsystem (400) nach Anspruch 3, wobei die Vielzahl von fahrzeugmontierten Komponenten (440, 442, 443) jeweils mit einer Vielzahl von Rohrleitungen verbunden ist, die Vielzahl von Rohrleitungen parallel verbunden ist, die Vielzahl von Rohrleitungen jeweils mit der Pumpe (410) und dem Wärmetauscher (420) verbunden ist, um einen Kreislauf zu bilden, und das fahrzeugmontierte Steuerungsmodul (430) über Leitungen separat mit der Pumpe (410) und der Vielzahl von fahrzeugmontierten Komponenten (440, 442, 443) verbunden ist.

5. Flüssigkeitskühlsystem (400) nach Anspruch 3 oder 4, wobei das Flüssigkeitskühlsystem (400) ferner einen Temperatursensor (450) umfasst, wobei sich der Temperatursensor (450) an einem Flüssigkeitskühleinlass der Vielzahl von fahrzeugmontierten Komponenten (440, 442, 443) befindet und der Temperatursensor (450) dazu konfiguriert ist, die Einlasswassertemperatur zu messen.

6. Flüssigkeitskühlsystem (400) nach Anspruch 1, wobei die Pumpendrehzahlanforderung der intelligenten Antriebssteuerungskomponente (440, 441) basierend auf einem kleinsten Wert der Temperaturdifferenzen an der Vielzahl von Stellen auf der intelligenten Antriebssteuerungskomponente (440, 441) bestimmt wird.

7. Steuerungsverfahren (600), das auf ein Flüssigkeitskühlsystem (400) angewendet wird, wobei das Flüssigkeitskühlsystem (400) eine Pumpe (410), einen Wärmetauscher (420) und eine Vielzahl von fahrzeugmontierten Komponenten (440, 442, 443) umfasst, die Vielzahl von fahrzeugmontierten Komponenten (440, 442, 443) eine intelligente Antriebssteuerungskomponente (440, 441) umfasst und die Pumpe (410) dazu konfiguriert ist, eine Flüssigkeit an die Vielzahl von fahrzeugmontierten Komponenten (440, 442, 443) zu liefern, um Wärme für die Vielzahl von fahrzeugmontierten Komponenten (440, 442, 443) abzuführen; und
wobei das Steuerungsverfahren (600) Folgendes umfasst:
Erlangen von Pumpendrehzahlanforderungen der Vielzahl von fahrzeugmontierten Komponenten (440, 442, 443); und
Bestimmen einer Drehzahl der Pumpe (410) basierend auf den Pumpendrehzahlanforderungen der Vielzahl von fahrzeugmontierten Komponenten (440, 442, 443); und
Bestimmen einer Pumpendrehzahlanforderung der intelligenten Antriebssteuerungskomponente (440, 441) basierend auf Temperaturdifferenzen an einer Vielzahl von Stellen auf der intelligenten Antriebssteuerungskomponente (440, 441), wobei jede Temperaturdifferenz eine Differenz zwischen einer Temperaturangabe und einer tatsächlichen Temperatur ist;
wobei das Bestimmen einer Pumpendrehzahlanforderung der intelligenten Antriebssteuerungskomponente (440, 441) basierend auf Temperaturdifferenzen an einer Vielzahl von Stellen auf der intelligenten Antriebssteuerungskomponente (440, 441) Folgendes umfasst:
Bestimmen der Pumpendrehzahlanforderung der intelligenten Antriebssteuerungskomponente (440, 441) basierend auf einem kleinsten Wert der Temperaturdifferenzen an der Vielzahl von Stellen auf der intelligenten Antriebssteuerungskomponente (440, 441).

8. Steuerungsverfahren (600) nach Anspruch 7, wobei das Bestimmen einer Drehzahl der Pumpe (410) basierend auf den Pumpendrehzahlanforderungen der Vielzahl von fahrzeugmontierten Komponenten (440, 442, 443) Folgendes umfasst:
Bestimmen der Drehzahl der Pumpe (410) basierend auf einem größten Wert der Pumpendrehzahlanforderungen der Vielzahl von fahrzeugmontierten Komponenten (440, 442, 443).

9. Steuerungsverfahren (600) nach Anspruch 7 oder 8, wobei das Steuerungsverfahren (600) ferner Folgendes umfasst:
Bestimmen der Pumpendrehzahlanforderungen der Vielzahl von fahrzeugmontierten Komponenten (440, 442, 443) basierend auf einer Einlasswassertemperatur und einer Durchflussanforderung jeder der Vielzahl von fahrzeugmontierten Komponenten (440, 442, 443).

10. Steuerungsverfahren (600) nach Anspruch 7, wobei das Bestimmen der Pumpendrehzahlanforderung der intelligenten Antriebssteuerungskomponente (440, 441) basierend auf einem kleinsten Wert der Temperaturdifferenzen an der Vielzahl von Stellen auf der intelligenten Antriebssteuerungskomponente (440, 441) Folgendes umfasst:
Bestimmen eines Temperaturbereichs, in den der kleinste Wert der Temperaturdifferenzen an der Vielzahl von Stellen auf der intelligenten Antriebssteuerungskomponente (440, 441) fällt; und
Bestimmen der Pumpendrehzahlanforderung der intelligenten Antriebssteuerungskomponente (440, 441) basierend auf dem Temperaturbereich, in den der kleinste Wert der Temperaturdifferenzen an der Vielzahl von Stellen auf der intelligenten Antriebssteuerungskomponente (440, 441) fällt.

11. Steuerungsverfahren (600) nach einem der Ansprüche 7 bis 9, wobei das Steuerungsverfahren (600) ferner Folgendes umfasst:
Bestimmen einer Pumpendrehzahlanforderung der intelligenten Antriebssteuerungskomponente (440, 441) basierend auf den Temperaturdifferenzen und Aufwärmraten an der Vielzahl von Stellen auf der intelligenten Antriebssteuerungskomponente (440, 441), wobei jede Temperaturdifferenz eine Differenz zwischen einer Temperaturangabe und einer tatsächlichen Temperatur ist.

12. Steuerungseinrichtung (700), die auf ein Flüssigkeitskühlsystem (400) nach einem oder mehreren der Ansprüche 1 bis 6 angewendet wird, die eine Eingabe-/Ausgabeschnittstelle, einen Prozessor (103, 113, 330, 820) und einen Speicher (114, 135, 340, 810) umfasst, wobei der Prozessor (103, 113, 330, 820) dazu konfiguriert ist, die Eingabe-/Ausgabeschnittstelle zu steuern, um ein Signal oder Informationen zu empfangen oder zu senden, der Speicher (114, 135, 340, 810) dazu konfiguriert ist, ein Computerprogramm zu speichern, und der Prozessor (103, 113, 330, 820) dazu konfiguriert ist, das Computerprogramm aus dem Speicher (114, 135, 340, 810) aufzurufen und auszuführen, so dass die Steuerungseinrichtung (700) das Flüssigkeitskühlsystem dazu veranlasst, das Steuerungsverfahren (600) nach einem der Ansprüche 7 bis 11 durchzuführen.

## Revendications

1. Système de refroidissement par liquide (400), dans lequel le système de refroidissement par liquide (400) comprend une pompe (410), un échangeur de chaleur (420), un module de commande monté sur un véhicule (430), et une pluralité de composants montés sur un véhicule (440, 442, 443), dans lequel la pluralité de composants montés sur un véhicule (440, 442, 443) comprennent un composant de commande de conduite intelligente (440, 441) ; la pompe (410) est configurée pour distribuer du liquide à la pluralité de composants montés sur un véhicule (440, 442, 443), pour dissiper la chaleur de la pluralité de composants montés sur un véhicule (440, 442, 443) ; et
le module de commande monté sur un véhicule (430) est configuré pour déterminer une vitesse de rotation de la pompe (410) sur la base d'exigences de vitesse de rotation de la pompe de la pluralité de composants montés sur un véhicule (440, 442, 443) ; et
dans lequel une exigence de vitesse de rotation de la pompe du composant de commande de conduite intelligente (440, 441) est déterminée sur la base de différences de température au niveau d'une pluralité d'emplacements sur le composant de commande de conduite intelligente (440, 441), et chaque différence de température est une différence entre une spécification de température et une température réelle.

2. Système de refroidissement par liquide (400) selon la revendication 1, dans lequel le module de commande monté sur un véhicule (430) est également configuré pour déterminer la vitesse de rotation de la pompe (410) sur la base d'une plus grande valeur des exigences de vitesse de rotation de la pompe de la pluralité de composants montés sur un véhicule (440, 442, 443).

3. Système de refroidissement par liquide (400) selon la revendication 1 ou 2, dans lequel une exigence de vitesse de rotation de la pompe de chacun de la pluralité de composants montés sur un véhicule (440, 442, 443) est déterminée sur la base d'une température d'eau d'entrée et d'une exigence de débit de chaque composant monté sur un véhicule (440, 442, 443).

4. Système de refroidissement par liquide (400) selon la revendication 3, dans lequel la pluralité de composants montés sur un véhicule (440, 442, 443) sont respectivement connectés à une pluralité de canalisations, la pluralité de canalisations sont connectées en parallèle, la pluralité de canalisations sont respectivement connectées à la pompe (410) et à l'échangeur de chaleur (420) pour former une boucle de circulation, et le module de commande monté sur un véhicule (430) est connecté séparément à la pompe (410) et à la pluralité de composants montés sur un véhicule (440, 442, 443) par des conduites.

5. Système de refroidissement par liquide (400) selon la revendication 3 ou 4, dans lequel le système de refroidissement par liquide (400) comprend également un capteur de température (450), le capteur de température (450) est situé au niveau d'une entrée de refroidissement par liquide de la pluralité de composants montés sur un véhicule (440, 442, 443), et le capteur de température (450) est configuré pour mesurer la température d'eau d'entrée.

6. Système de refroidissement par liquide (400) selon la revendication 1, dans lequel l'exigence de vitesse de rotation de la pompe du composant de commande de conduite intelligente (440, 441) est déterminée sur la base d'une plus petite valeur des différences de température au niveau de la pluralité d'emplacements sur le composant de commande de conduite intelligente (440, 441).

7. Procédé de commande (600) appliqué à un système de refroidissement par liquide (400), dans lequel le système de refroidissement par liquide (400) comprend une pompe (410), un échangeur de chaleur (420), et une pluralité de composants montés sur un véhicule (440, 442, 443), la pluralité de composants montés sur un véhicule (440, 442, 443) comprennent un composant de commande de conduite intelligente (440, 441), et la pompe (410) est configurée pour distribuer du liquide à la pluralité de composants montés sur un véhicule (440, 442, 443), pour dissiper la chaleur de la pluralité de composants montés sur un véhicule (440, 442, 443) ; et
le procédé de commande (600) comprend :
l'obtention d'exigences de vitesse de rotation de la pompe de la pluralité de composants montés sur un véhicule (440, 442, 443) ; et
la détermination d'une vitesse de rotation de la pompe (410) sur la base des exigences de vitesse de rotation de la pompe de la pluralité de composants montés sur un véhicule (440, 442, 443) ; et
la détermination d'une exigence de vitesse de rotation de la pompe du composant de commande de conduite intelligente (440, 441) sur la base de différences de température au niveau d'une pluralité d'emplacements sur le composant de commande de conduite intelligente (440, 441), dans lequel chaque différence de température est une différence entre une spécification de température et une température réelle ;
dans lequel la détermination d'une exigence de vitesse de rotation de la pompe du composant de commande de conduite intelligente (440, 441) sur la base de différences de température au niveau d'une pluralité d'emplacements sur le composant de commande de conduite intelligente (440, 441) comprend :
la détermination de l'exigence de vitesse de rotation de la pompe du composant de commande de conduite intelligente (440, 441) sur la base d'une plus petite valeur des différences de température au niveau de la pluralité d'emplacements sur le composant de commande de conduite intelligente (440, 441).

8. Procédé de commande (600) selon la revendication 7, dans lequel la détermination d'une vitesse de rotation de la pompe (410) sur la base des exigences de vitesse de rotation de la pompe de la pluralité de composants montés sur un véhicule (440, 442, 443) comprend :
la détermination de la vitesse de rotation de la pompe (410) sur la base d'une plus grande valeur des exigences de vitesse de rotation de la pompe de la pluralité de composants montés sur un véhicule (440, 442, 443).

9. Procédé de commande (600) selon la revendication 7 ou 8, dans lequel le procédé de commande (600) comprend également :
la détermination des exigences de vitesse de rotation de la pompe de la pluralité de composants montés sur un véhicule (440, 442, 443) sur la base d'une température d'eau d'entrée et d'une exigence de débit de chacun de la pluralité de composants monté sur un véhicule (440, 442, 443).

10. Procédé de commande (600) selon la revendication 7, dans lequel la détermination de l'exigence de vitesse de rotation de la pompe du composant de commande de conduite intelligente (440, 441) sur la base d'une plus petite valeur des différences de température au niveau de la pluralité d'emplacements sur le composant de commande de conduite intelligente (440, 441) comprend :
la détermination d'une plage de température dans laquelle se situe la plus petite valeur des différences de température au niveau de la pluralité d'emplacements sur le composant de commande de conduite intelligente (440, 441) ; et
la détermination de l'exigence de vitesse de rotation de la pompe du composant de commande de conduite intelligente (440, 441) sur la base de la plage de température dans laquelle se situe plus petite valeur des différences de température au niveau de la pluralité d'emplacements sur le composant de commande de conduite intelligente (440, 441).

11. Procédé de commande (600) selon l'une quelconque des revendications 7 à 9, dans lequel le procédé de commande (600) comprend également :
la détermination d'une exigence de vitesse de rotation de la pompe du composant de commande de conduite intelligente (440, 441) sur la base des différences de température et des vitesses de chauffage au niveau d'une pluralité d'emplacements sur le composant de commande de conduite intelligente (440, 441), dans lequel chaque différence de température est une différence entre une spécification de température et une température réelle.

12. Appareil de commande (700) appliqué à un système de refroidissement par liquide (400) selon l'une ou plusieurs des revendications 1 à 6, comprenant une interface d'entrée/sortie, un processeur (103, 113, 330, 820), et une mémoire (114, 135, 340, 810), dans lequel le processeur (103, 113, 330, 820) est configuré pour commander l'interface d'entrée/sortie pour recevoir ou envoyer un signal ou des informations, la mémoire (114, 135, 340, 810) est configurée pour stocker un programme informatique, et le processeur (103, 113, 330, 820) est configuré pour invoquer et exécuter le programme informatique à partir de la mémoire (114, 135, 340, 810), de sorte que l'appareil de commande (700) amène le système de refroidissement par liquide à réaliser le procédé de commande (600) selon l'une quelconque des revendications 7 à 11.
